(19) Europäisches Patentamt / European Patent Office / Office européen des brevets

(11) **EP 4 106 199 B1**

(12) **FASCICULE DE BREVET EUROPEEN**

(45) Date de publication et mention
de la délivrance du brevet:
**28.08.2024   Bulletin 2024/35**

(21) Numéro de dépôt: **22178474.7**

(22) Date de dépôt: **10.06.2022**

(51) Classification Internationale des Brevets (IPC):
*H03K 17/16* (2006.01)   *H03K 17/693* (2006.01)
*H03K 17/00* (2006.01)   *H03K 19/0944* (2006.01)
*H02J 1/10* (2006.01)   *H03K 17/30* (2006.01)
*G05F 1/56* (2006.01)   *G06F 1/26* (2006.01)
*G05F 1/59* (2006.01)   *H03K 19/00* (2006.01)

(52) Classification Coopérative des Brevets (CPC):
**H03K 17/162; G05F 1/59; G06F 1/263;
H03K 17/005; H03K 17/302; H03K 17/693;
H03K 19/0016;** H02J 1/082; H02J 1/084;
H02J 2310/20; Y02D 10/00

(54) **DISPOSITIF DE SÉLECTION DE TENSION D'ALIMENTATION AVEC COMMUTATIONS CONTRÔLÉES EN TENSION ET EN COURANT**

VORRICHTUNG ZUR AUSWAHL DER VERSORGUNGSSPANNUNG MIT KONTROLLIERTEN SPANNUNGS- UND STROMUMSCHALTUNGEN

DEVICE FOR SELECTING SUPPLY VOLTAGE WITH VOLTAGE- AND CURRENT-CONTROLLED SWITCHES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **14.06.2021   FR 2106236**

(43) Date de publication de la demande:
**21.12.2022   Bulletin 2022/51**

(73) Titulaire: **Commissariat à l'énergie atomique
et aux énergies alternatives
75015 Paris (FR)**

(72) Inventeurs:
• **AWAD, Mohamad
  38054 Grenoble Cedex 09 (FR)**
• **PILLONNET, Gaël
  38054 Grenoble Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
**EP-A1- 1 993 019**       **CN-A- 106 873 696**
**US-A1- 2005 057 952**

EP 4 106 199 B1

**Description**

La présente invention concerne le domaine des circuits électroniques à plusieurs tensions d'alimentation et plus particulièrement un circuit de sélection de tension d'alimentation pour un circuit intégré multi-coeur.

Dans certains dispositifs électroniques, on souhaite pouvoir modifier le niveau de la tension d'alimentation d'un circuit intégré, par exemple pour optimiser la gestion de l'énergie électrique dans le dispositif. De préférence, cette modification du niveau de la tension d'alimentation doit pouvoir se faire de façon dynamique, sans interrompre le fonctionnement du circuit intégré.

Plus particulièrement, la gestion dynamique du niveau de la tension d'alimentation est indispensable dans le cas des circuits de calcul à haute performance HPC (acronyme de l'expression High Performance Computing). Les nouvelles architectures de processeurs de calcul haute performance sont généralement divisées en plusieurs noyaux. On parle dans cas de processeurs multi-coeurs.

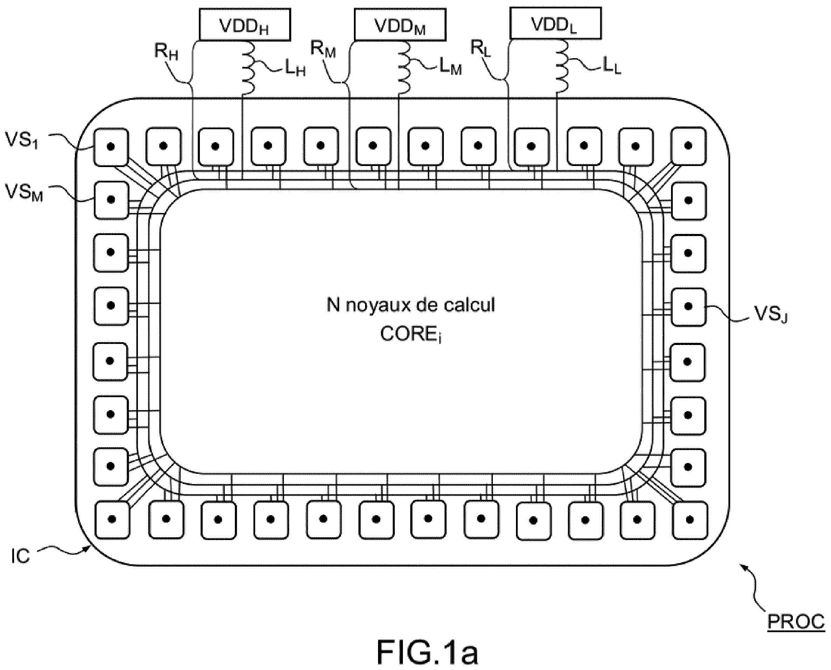

La figure 1a illustre un schéma d'un exemple de circuit électronique comprenant une pluralité de noyaux avec une gestion de tension d'alimentation. L'exemple comprend trois sources de tensions d'alimentation à titre illustratif et non limitatif.

Le circuit électronique illustré est un processeur multicoeur PROC comprenant une pluralité de sources de tensions d'alimentation $VDD_H$ $VDD_M$ et $VDD_L$ tel que $VDD_H < VDD_M < VDD_L$ ; N noyaux de calcul $CORE_i$ et M circuits sélecteurs de tension d'alimentation VSi, avec N un entier naturel supérieur à 1 et i un entier naturel de 1 à N et avec M un entier naturel supérieur à 1 et j un entier naturel de 1 à M. Chaque circuit sélecteur de tension $VS_j$ est configuré pour fournir à au moins un noyau de calcul $CORE_i$, une tension d'alimentation choisie parmi $VDD_H$ $VDD_M$ $VDD_L$..

Les noyaux $CORE_i$ fonctionnent à des fréquences différentes. Les charges de travail à la sortie de chaque noyau $CORE_i$ changent de manière dynamique lors de la réalisation des calculs. Pour chaque noyau $CORE_i$ la tension d'alimentation détermine la puissance de calcul et le coût énergétique des opérations logiques. En effet, un noyau de calcul fonctionnant en plein régime de calcul doit être alimenté par la tension maximale $VDD_H$ ; un noyau de calcul fonctionnant lors d'une activité de calcul moyenne peut être alimenté par la tension moyenne $VDD_M$ ; et un noyau de calcul mis en veille requiert seulement la tension minimale $VDD_L$ . Ainsi, la quantité d'opérations de calcul à réaliser et le processus algorithmique utilisé par chaque noyau $CORE_i$ déterminent les moyens de calcul requis et ainsi la tension d'alimentation requise pour ledit noyau en temps réel. Lors d'un changement d'activité d'un noyau $CORE_i$, la tension d'alimentation dudit noyau doit être ajustée pour minimiser le produit temps de calcul par consommation énergétique, cette technique est appelée ajustement dynamique de la tension (en anglais dynamic voltage scaling). Il est particulièrement intéressant de ne pas interrompre l'activité du coeur pendant les transitions entre deux niveaux d'alimentation. Les circuits sélecteurs de tension $VS_j$ permettent d'implémenter une gestion dynamique de la tension d'alimentation pour un grand nombre N de noyaux $CORE_i$ (N>10).

Dans l'architecture présentée, les N noyaux de calcul $CORE_i$ et M circuits sélecteurs de tension d'alimentation $VS_j$ sont implémentés sur la même puce IC et les sources de tensions d'alimentation $VDD_H$ $VDD_M$ et $VDD_L$ sont externes à la puce IC. Les tensions d'alimentation $VDD_H$ $VDD_M$ et $VDD_L$ sont respectivement propagées vers la puce IC via les rails d'alimentations communs $R_H$, $R_M$ et $R_L$ . Les rails d'alimentation communs étant réalisés via des matériaux conducteurs présentent toujours des effets inductifs parasites (ou d'auto-induction) présentés ici par les inductances parasites $L_H$, $L_M$ et $L_L$. Lors d'une transition d'une tension d'alimentation à une autre, les inductances parasites liées aux sources des tensions d'alimentation voient une forte variation de courant dans une brève période de temps ce qui génère une variation de tension aux bornes de l'inductance et donc sur les rails d'alimentation. On parle ici de « bruit de commutation » en L.di/dt. Ce type de bruit perturbe pendant les transitions les niveaux de tension d'alimentation des différents noyaux de calcul $CORE_i$ et donc perturber le fonctionnement de l'ensemble du circuit électronique PROC. Il y a donc un effet inductif non négligeable couplant électriquement les coeurs qui sont connectés sur le même rail commun. Pendant les transitions, la variation quasi-instantanée du courant sur les rails communs, se traduit par une variation de tension sur les rails communs. Cette perturbation va se répercuter sur l'ensemble des coeurs alimentés par ceux-ci et donc modifier le fonctionnement de ces coeurs.

La perturbation de l'alimentation subie par un noyau de calcul génère des erreurs de calcul. En effet, la fréquence de travail d'un noyau a été conçue pour être compatible avec une valeur de tension d'alimentation à priori fixe. Les perturbations à cause du phénomène d'auto-induction vont ainsi créer un incompatibilité entre la tension d'alimentation et la fréquence de travail du noyau de calcul.

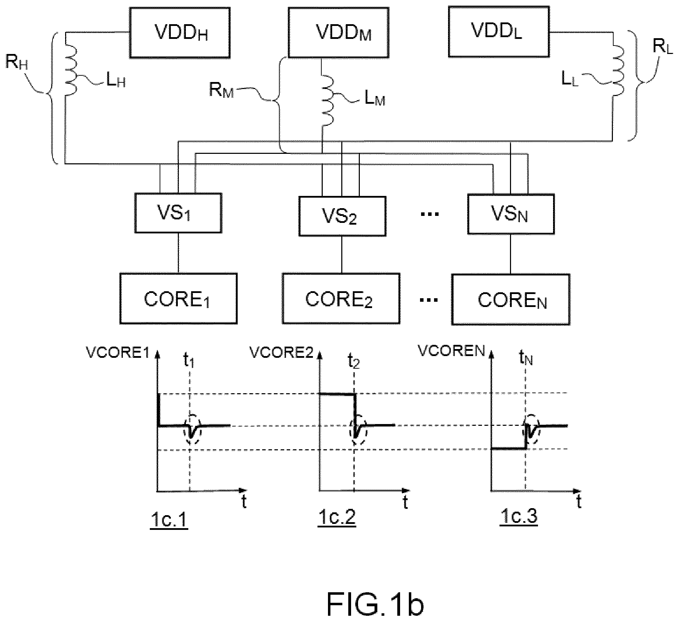

La figure 1b illustre le problème de bruit de commutation à cause des inductances intrinsèques parasites lors d'un ou plusieurs changements de tension d'alimentation dans un circuit multicoeur avec ajustement dynamique de la tension. Le chronogramme 1c.1 illustre la variation temporelle de la tension $VCORE_1$ qui alimente le noyau de calcul $CORE_1$ choisie par le circuit de sélection de tension $VS_1$. Le chronogramme 1c.2 illustre la variation temporelle de la tension $VCORE_2$ qui alimente le noyau de calcul $CORE_2$ choisie par le circuit de sélection de tension $VS_2$. Le chronogramme 1c.3 illustre, plus généralement, la variation temporelle de la tension $VCORE_n$ qui alimente un noyau de calcul quelconque $CORE_n$ choisi par le circuit de sélection de tension associé $VS_n$.

A t1, la tension $VCORE_1$ est configurée pour rester constante au niveau de tension moyen $VDD_M$ , la

tension VCORE$_2$ est configurée pour faire une transition descendante du niveau de tension haut VDD$_H$ vers le niveau de tension moyen VDD$_M$, la tension VCORE$_N$ est configurée pour faire une transition montante du niveau de tension bas VDD$_L$ vers le niveau de tension moyen VDD$_M$. Les commutations brusques et simultanées provoquent des appels de courant forts dans les inductances parasites L$_M$, L$_L$ et L$_H$ dans un intervalle de temps réduit. Ainsi, les transitions réalisées pour changer l'alimentation du noyau CORE$_2$ et du noyau CORE$_N$ perturbent le rail commun R$_M$ du niveau de tension d'alimentation moyen VDD$_M$. Cette perturbation est observable sur tous les noeuds d'alimentation VCORE$_1$ VCORE$_2$ jusqu'à VCORE$_N$. A titre d'exemple, on observe une perturbation sous forme chute de tension (power drop en Anglais) sur le noeud d'alimentation VCORE$_1$ qui est normalement configuré pour rester constante au niveau de tension moyen VDD$_M$. Ainsi, l'élimination de la perturbation de la transition du niveau d'alimentation d'un noyau sur ceux des autres noyaux par couplage inductif des rails communs, nécessite que les transitions entre deux niveaux d'alimentation soient contrôlées en tension, mais aussi en courant. On considère qu'une tension d'alimentation est « non perturbée » lorsque les variations de cette tension sont inférieures à 5% du niveau de tension visé.

D'autre part, il n'est pas envisageable de se contenter de ralentir la pente de transition lors de la commutation d'un niveau d'alimentation à un autre niveau pour limiter le bruit de commutation. En effet, cette approche présente un autre risque pour le circuit consistant en l'apparition de courants inverses dans les rails communs d'alimentation, ce qui perturbe le bon fonctionnement du circuit électronique PROC.

Pour résumer, nous avons démontré que : d'une part, les variations brusques de courant dans les rails d'alimentation lors d'une transition d'un niveau de tension d'alimentation à un autre génèrent des bruits de commutation dû à l'effet inductif parasite. D'autre part, le phénomène de courant inverse présente une contrainte technique qui limite le recours au ralentissement de la pente de transition.

Le problème technique à résoudre est alors de développer des circuits de sélection de tension d'alimentation permettant l'ajustement dynamique de la tension tout en limitant le bruit de commutation dû à l'effet inductif parasite des rails communs d'alimentation et en évitant le phénomène de courants inverses dans lesdits rails communs.

Le brevet européen EP3267583B1 propose une architecture de circuit de sélection de tension d'alimentation permettant de contrôler la forme de la tension sur le rail d'alimentation d'un circuit coeur de calcul pendant la transition d'un niveau de tension d'alimentation à un autre niveau . L'inconvénient de la solution proposée par le brevet précité consiste en ce qu'elle se limite à un contrôle en tension et ne tient pas en compte des forts appels de courants sur chaque rail commun. Les variations de courant ne sont pas contrôlées et le problème de bruit de commutation résultant des inductances parasites n'est pas résolu.

Le brevet américain US10439602B2 propose une architecture de circuit de sélection de tension d'alimentation permettant de basculer entre deux rails d'alimentation une principale et une auxiliaire, selon la tension disponible. Si la tension principale devient plus petite d'un seuil défini, la tension auxiliaire est utilisée afin de réguler la tension de sortie et de la remettre au niveau voulu. L'inconvénient de la solution proposée par le brevet précité consiste en ce le fonctionnement de la solution nécessite le maintien des interrupteurs de puissance de la source principale et auxiliaire à l'état passant simultanément. Cela engendre des courants inverses dans le circuit réduisant les performances calculatoires et énergétiques du circuit. De plus, la solution proposée par le brevet précité nécessite l'implémentation de quatre comparateurs afin de détecter les états des deux rails et Le fonctionnement permanent d'au moins deux comparateurs. Cela fait augmenter considérablement la consommation énergétique du circuit de sélection tension d'alimentation.

Le brevet américain US10432184B1 propose une architecture de circuit de sélection de tension d'alimentation comprenant un multiplexeur de courant permettant de réaliser des transitions douces afin de limiter les appels au courant. L'inconvénient de la solution proposée par le brevet précité consiste en ce qu'elle nécessite l'implémentation d'un élément capacitif présentant une grande capacité. Cela induit une augmentation considérable de la surface occupée par le dispositif dans sa globalité et pose alors des contraintes d'intégration matérielle. De plus, la solution proposée par le brevet montre des durées de transition très longues la rendant non compatible avec des applications fonctionnant à haute fréquence.

La demande de brevet européen EP3734398A1 propose une architecture de circuit de sélection de tension d'alimentation utilisant un seul rail d'alimentation en entrée permettant d'assurer simultanément une tension principale et une tension configurable. L'inconvénient de la solution proposée par le brevet précité consiste en ce qu'elle nécessite un fonctionnement permanent d'un comparateur ce qui fait augmenter considérablement la consommation énergétique du circuit de sélection tension d'alimentation. De plus, la solution de la demande de brevet ne tient pas en compte des forts appels de courants sur chaque rail commun. Les variations de courant ne sont pas contrôlées et le problème de bruit de commutation à cause des inductances parasites n'est pas résolu.

L'état de la technique comprend de plus les demandes de Brevet EP1993019A1 et US2005/057952A1.

Pour pallier les limitations des solutions existantes en ce qui concerne permettant l'ajustement dynamique de la tension tout en limitant le bruit de commutation inductif d'alimentation et en évitant le phénomène de courants inverses, l'invention propose différents modes de réalisation d'une architecture de circuit de sélection permettant de réaliser des transitions montante et/ou descendante selon des jeux de séquencement de phases lentes et rapides de manière à résoudre en même temps les problèmes de bruits inductifs de commutation et les problèmes de courants dans les rails d'alimentations. Cette solution présente plusieurs avantages liés à la facilité d'implémentation et la flexibilité de configurations possibles pour d'adapter aux contraintes spécifiques lors de la conception du circuit.

L'invention a pour objet un circuit de sélection d'une tension d'alimentation, comprenant :

- un premier noeud adapté à recevoir une première tension d'alimentation d'entrée;

- un deuxième noeud adapté à recevoir une seconde tension d'alimentation d'entrée inférieure à la première tension d'alimentation d'entrée ;

- un troisième noeud adapté à fournir une tension d'alimentation de sortie;

- un premier transistor de puissance reliant le premier noeud au troisième noeud ;

- un second transistor de puissance reliant le deuxième noeud au troisième noeud ;

- et un circuit de configuration adapté dans une première configuration, à maintenir les premier et deuxième transistors respectivement passant et bloquant de façon à appliquer la première tension d'alimentation d'entrée sur le troisième noeud, et, dans une seconde configuration, à maintenir les premier et deuxième transistors respectivement en état bloquant et passant de façon à appliquer la seconde tension d'alimentation d'entrée sur le troisième noeud;

  une phase de transition de la première configuration à la seconde configuration étant dénommée transition descendante ;

  une phase de transition de la seconde configuration à la première configuration étant dénommée transition montante ;

  le circuit de configuration comprenant :

- un premier circuit de gestion de transition configuré pour commander la grille du premier transistor lors de la transition montante ou descendante de manière à appliquer sur le troisième noeud :

  ◦ au moins une première rampe de tension ayant une première pente pendant une première durée définissant une phase lente;

  ◦ et une seconde rampe de tension ayant une seconde pente étant supérieure à la première pente pendant une deuxième durée définissant une phase rapide,

- un second circuit de gestion de transition configuré pour commander la grille du second transistor lors de la transition montante ou descendante de manière à appliquer un signal de commande présentant une variation graduelle.

Selon un aspect particulier de l'invention, la valeur absolue de la première pente est comprise entre un dixième de la valeur absolue de la deuxième pente et un cinquième de la valeur absolu deuxième pente.

Selon un aspect particulier de l'invention, le circuit de configuration, pour réaliser une transition montante, est configuré pour exécuter successivement les étapes suivantes :

  i- commander le premier transistor en régime linéaire pour appliquer la première rampe de tension sur le troisième noeud durant la phase lente;

  ii- détecter le passage de la tension d'alimentation de sortie à un niveau supérieur à un seuil prédéterminé inférieur à la première tension d'alimentation d'entrée, ledit passage indiquant l'achèvement de la phase lente ;

  iii- commander le premier transistor en régime linéaire pour appliquer une tension constante sur le troisième noeud pendant une phase intermédiaire entre la phase lente et la phase rapide;

  iv- et appliquer, pendant la phase intermédiaire, un signal de commande présentant une variation graduelle sur la grille du second transistor pour basculer graduellement le second transistor à un état bloquant ;

  v- commander le premier transistor en régime linéaire pour appliquer la seconde rampe de tension sur le troisième noeud durant la phase rapide jusqu'au passage du premier transistor à un état passant.

Selon un aspect particulier de l'invention, le circuit de configuration, pour réaliser une transition descendante, est configuré pour exécuter successivement les étapes suivantes :

  i- commander le premier transistor en régime linéaire pour appliquer la seconde rampe de tension sur le troisième noeud durant la phase rapide;

  ii- détecter le passage de la tension d'alimentation de sortie à un niveau supérieur à un niveau inférieur à un seuil prédéterminé supérieur la seconde tension d'alimentation d'entrée, ledit passage indiquant l'achèvement de la phase rapide ;

iii- appliquer, pendant la phase lente, un signal de commande présentant une variation graduelle sur la grille du second transistor pour basculer graduellement le second transistor à un état passant ;

iv- et commander le premier transistor en régime linéaire pour appliquer la première rampe de tension sur le troisième noeud durant la phase lente jusqu'au passage du premier transistor à un état bloquant.

Selon un aspect particulier de l'invention, le circuit de configuration, pour réaliser une transition montante, est configuré pour exécuter successivement les étapes suivantes :

i- appliquer un second signal de commande présentant une variation graduelle sur la grille du premier transistor durant la phase lente ;

ii- détecter le passage de la tension d'alimentation de sortie à un niveau supérieur à un seuil prédéterminé inférieur à la première tension d'alimentation d'entrée, ledit passage indiquant l'achèvement de la phase lente ;

iii- commander le premier transistor en régime linéaire pour appliquer une tension constante sur le troisième noeud pendant une phase intermédiaire entre la phase lente et la phase rapide ;

iv- et appliquer, pendant la phase intermédiaire, un signal de commande présentant une variation graduelle sur la grille du second transistor pour basculer graduellement le second transistor à un état bloquant ;

v- commander le premier transistor en régime linéaire pour appliquer la seconde rampe de tension sur le troisième noeud durant la phase rapide jusqu'au passage du premier transistor à un état passant.

Selon un aspect particulier de l'invention, le circuit de configuration, pour réaliser une transition descendante, est configuré pour exécuter successivement les étapes suivantes :

i- commander le premier transistor en régime linéaire pour appliquer la seconde rampe de tension sur le troisième noeud durant la phase rapide ;

ii- détecter le passage de la tension d'alimentation de sortie à un niveau supérieur à un niveau inférieur à un seuil prédéterminé supérieur la seconde tension d'alimentation d'entrée, ledit passage indiquant l'achèvement de la phase rapide ;

iii- appliquer, pendant la phase lente, un premier signal de commande présentant une variation graduelle sur la grille du second transistor pour basculer graduellement le second transistor à un état passant ;

iv- et appliquer un second signal de commande présentant une variation graduelle sur la grille du premier transistor de manière à appliquer la première rampe de tension sur le troisième noeud durant la phase lente ; pour basculer graduellement le premier transistor à un état bloquant.

Selon un aspect particulier de l'invention, le circuit de contrôle comprend :

- un générateur de rampes de tension pour générer :

  ○ la première rampe de tension montante ou descendante,

  ○ et/ou la deuxième rampe de tension montante ou descendante sur un noeud de sortie.

- et dans lequel le premier circuit de gestion de transition comprend un premier circuit de régulation linéaire pour commander le premier transistor en régime linéaire, et ayant :

  ○ un premier noeud d'entrée connecté au troisième noeud,

  ○ un deuxième noeud d'entrée connecté au noeud de sortie du générateur de rampes,

  ○ et un noeud de sortie connecté à la grille du premier transistor à travers un premier interrupteur.

Selon un aspect particulier de l'invention, le premier circuit de régulation linéaire est configuré pour commander le premier transistor en régime linéaire via l'asservissement de la tension d'alimentation de sortie sur la rampe de tension appliquée au deuxième noeud d'entrée lorsque le premier interrupteur est passant.

Selon un aspect particulier de l'invention, le premier circuit de gestion de transition comprend en outre un premier circuit de transition graduelle ayant un noeud de sortie connecté à la grille du premier transistor à travers un deuxième interrupteur, le premier circuit de transition graduelle étant apte appliquer un signal de commande présentant une variation graduelle sur la grille du second transistor lorsque le deuxième interrupteur est passant .

Selon un aspect particulier de l'invention, le circuit de configuration comprend en outre un second circuit de gestion de transition comprenant :

- un second circuit de régulation linéaire ayant :

  ◦ un premier noeud d'entrée connecté au troisième noeud,

  ◦ un deuxième noeud d'entrée connecté au noeud de sortie du générateur de rampes,

  ◦ et un noeud de sortie connecté à la grille du second transistor à travers un troisième interrupteur.

Selon un aspect particulier de l'invention, le second circuit de gestion de transition comprend un second circuit de transition graduelle ayant un noeud de sortie connecté à la grille du second transistor à travers un quatrième interrupteur, ledit circuit de transition graduelle étant apte appliquer un signal de commande sur la grille du second transistor lorsque le troisième interrupteur est passant ; ledit signal de commande présentant une variation croissante ou décroissante graduelle.

Selon un aspect particulier de l'invention, le circuit de configuration comprend en outre un circuit de comparaison de la tension d'alimentation de sortie à un seuil prédéterminé.

Selon un aspect particulier de l'invention, le circuit de configuration comprend en outre un circuit de génération d'une durée prédéterminé.

D'autres caractéristiques et avantages de la présente invention apparaîtront mieux à la lecture de la description qui suit en relation aux dessins annexés suivants.

[Fig. 1a] la figure 1a illustre un schéma d'un exemple de circuit électronique comprenant une pluralité de noyaux avec une gestion de tension d'alimentation.

[Fig. 1b] la figure 1b illustre le bruit de commutation à cause des inductances intrinsèques dans l'exemple de circuit électronique de la figure 1a.

[Fig. 2a] la figure 2a illustre un circuit électronique de sélection d'une tension d'alimentation selon un premier mode de réalisation de l'invention.

[Fig. 2b] la figure 2b illustre un chronogramme présentant un exemple d'un mode de fonctionnement pendant une transition montante du circuit selon le premier mode de réalisation.

[Fig. 2c] la figure 2c illustre un schéma fonctionnel présentant un exemple d'un mode de fonctionnement pendant une transition montante du circuit selon le premier mode de réalisation.

[Fig. 2d] la figure 2d illustre un schéma fonctionnel présentant un exemple d'un mode de fonctionnement pendant une transition descendante du circuit selon le premier mode de réalisation.

[Fig. 3a] la figure 3a illustre un circuit électronique de sélection d'une tension d'alimentation selon un second mode de réalisation de l'invention.

[Fig. 3b] la figure 4b illustre un exemple de réalisation d'un premier circuit de transition graduelle utilisé dans circuit de sélection d'une tension d'alimentation selon le second mode de réalisation de l'invention.

[Fig. 3c] la figure 3b illustre un chronogramme présentant un exemple d'un mode de fonctionnement pendant une transition descendante du circuit selon le second mode de réalisation.

[Fig. 3d] la figure 3c illustre un schéma fonctionnel présentant un exemple d'un mode de fonctionnement pendant une transition descendante du circuit selon le second mode de réalisation.

[Fig. 3e] la figure 3d illustre un schéma fonctionnel présentant un exemple d'un mode de fonctionnement pendant une transition montante du circuit selon le second mode de réalisation.

[Fig. 4a] la figure 4a illustre un exemple de réalisation d'un circuit de régulation linéaire de tension du circuit de sélection d'une tension d'alimentation selon l'invention.

[Fig. 4b] la figure 4b illustre un exemple de réalisation d'un second circuit de transition graduelle du circuit de sélection d'une tension d'alimentation selon l'invention.

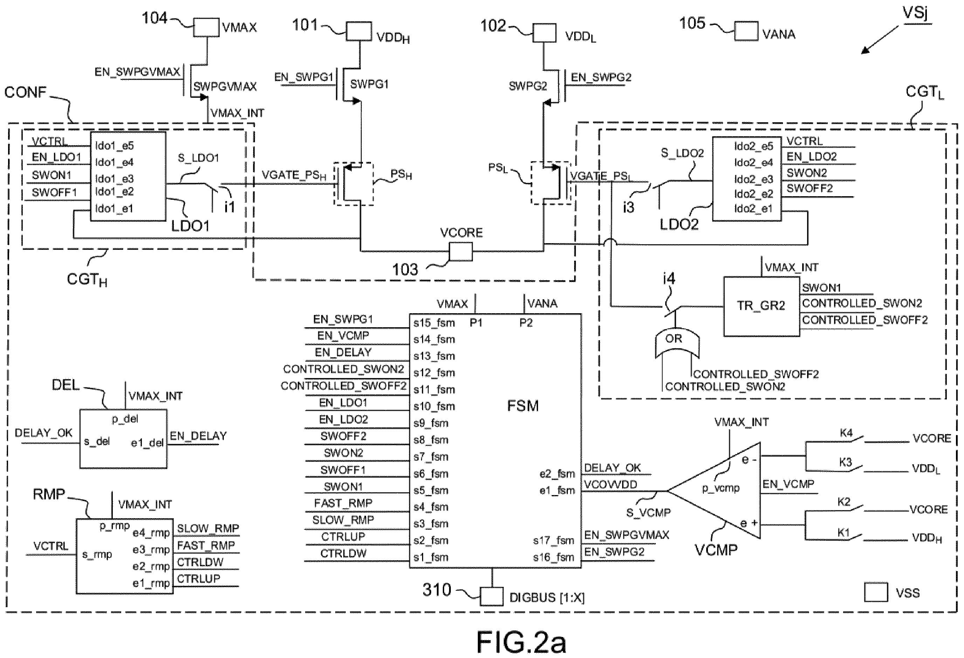

La figure 2a illustre un circuit électronique de sélection d'une tension d'alimentation VSj selon un premier mode de réalisation de l'invention. Le circuit de sélection d'une tension d'alimentation VSj de rang j fournit au noyau de calcul COREj de même rang j (non représenté) , la tension d'alimentation choisie selon les besoins de ressources du noyau tel que expliqué précédemment. Sans perte de généralité et par souci de simplification, nous allons nous limiter à l'illustration de l'invention avec deux niveaux de tension d'alimentation possibles : VDDH pour la tension d'alimentation haute et VDDL pour la tension d'alimentation basse. Les caractéristiques de l'invention restent généralisables pour une pluralité de niveaux de tension d'alimentation.

Le circuit de sélection d'une tension d'alimentation VSj comprend un premier noeud 101 adapté à recevoir une première tension d'alimentation d'entrée VDDH ; un deuxième noeud 102 adapté à recevoir une seconde tension d'alimentation d'entrée VDDL inférieure à la première tension d'alimentation d'entrée VDDH ; un troisième noeud 103 adapté à fournir une tension d'alimentation de sortie VCORE vers le noyau de calcul associé.

De plus, le circuit de sélection d'une tension d'alimentation VSj comprend un premier transistor de puissance PSH reliant le premier noeud 101 au troisième noeud 103 ; un second transistor de puissance PSL reliant le deuxième noeud 102 au troisième noeud 103. Dans l'exemple illustré, les transistors de puissance sont des transistors de type PMOS. Il est possible d'utiliser aussi des transistors de type NMOS tout en adaptant les signaux de commande à ce type de transistor.

De plus, le circuit de sélection d'une tension d'alimentation VSj comprend un circuit de configuration CONF adapté dans une première configuration, à maintenir les premier et deuxième transistors PSH et PSL, respectivement à un état passant et bloquant (ou bloqué) de façon à appliquer la première tension d'alimentation d'entrée $VDD_H$ sur le troisième noeud 103. Dans une seconde configuration, le circuit de configuration CONF est adapté à maintenir les premier et deuxième transistors $PS_H$ et $PS_L$ respectivement en état bloquant et passant de façon à appliquer la seconde tension d'alimentation d'entrée $VDD_L$ sur le troisième noeud 103.

Le circuit de sélection d'une tension d'alimentation $VS_j$ comprend en outre un quatrième noeud 104 adapté à recevoir une troisième tension d'alimentation VMAX égale à la tension d'alimentation maximale $VDD_H$ et utilisée pour alimenter le fonctionnement d'une partie ou de la totalité du circuit de configuration CONF.

Avantageusement, la source du transistor $PS_L$ de type PMOS n'est pas connectée directement au noeud 102 mais à travers un transistor de type NMOS noté SWPG2 présentant une résistivité, à l'état bloquant, supérieure à celle de $PS_L$ et permettant ainsi de réduire les courants de fuite via le noeud 102. Cela est obtenu en mettant le transistor SWPG2 à un état bloquant via le signal EN_SWPG2 lorsque le transistor $PS_L$ est dans un état bloquant. De même, la source du transistor $PS_H$ de type PMOS n'est pas connectée directement au noeud 101 mais à travers un transistor de type NMOS noté SWPG1 présentant une résistivité supérieure à celle de PSH et permettant ainsi de réduire les courants de fuite via le noeud 101 quand $VDD_H$ n'est pas sélectionné. Cela est obtenu en mettant le transistor SWPG1 à un état bloquant via le signal EN_SWPG1 lorsque le transistor $PS_H$ est dans un état bloquant. De même, le circuit de configuration CONF n'est pas connecté directement au noeud 104 mais à travers un transistor de type NMOS noté SWPGVMAX présentant une résistivité supérieure aux transistors des sous-blocs du circuit de configuration CONF et permettant ainsi de réduire les courants de fuite via le noeud 104. Le circuit de configuration CONF est ainsi alimenté avec la tension VMAX_INT au drain du transistor intermédiaire SWPGVMAX. La limitation des courants de fuite dans ce cas est obtenue en mettant le transistor SWPGVMAX à un état bloquant via le signal EN_SWPGVMAX lorsque le circuit de configuration est désactivé. A titre d'exemple, les transistors de limitation de fuite de courant SWPG1, SWPG2 et SWPGVMAX sont des transistors ayant une grille réalisée avec une couche d'oxyde plus épaisse que celle des transistors $PS_H$ et $PS_L$ de manière à obtenir une résistivité supérieure pour les transistors de limitation de fuite de courant.

De plus, Le circuit de sélection d'une tension d'alimentation $VS_j$ comprend en outre un cinquième noeud 105 adapté à recevoir une quatrième tension d'alimentation VANA supérieure à la tension d'alimentation maximale $VDD_H$ et utilisé pour alimenter le fonctionnement d'une partie ou de la totalité du circuit de configuration CONF et commander les transistors pour les transistors de limitation de fuite de courant.

Plus particulièrement, le circuit de configuration CONF comprend les sous-blocs suivants : un premier circuit de gestion de transition $CGT_H$, un second circuit de gestion de transition $CGT_L$, un comparateur COMP, un circuit de génération de rampes de tension montante ou descendante RMP, un circuit de génération de délai DEL et un circuit de séquencement asynchrone FSM mettant en oeuvre une machine d'état préalablement programmée.

Le premier circuit de gestion de transition $CGT_H$ est configuré pour commander la grille du premier transistor $PS_H$ lors de la transition montante ou descendante de manière à appliquer sur le troisième noeud 103 :

- au moins une première rampe de tension ayant une première pente pendant une première durée définissant une phase lente;

- et une seconde rampe de tension ayant une seconde pente étant supérieure à la première pente pendant une deuxième durée définissant une phase rapide.

Le premier circuit de gestion de transition $CGT_H$ comprend un premier circuit de régulation linéaire LDO1 pour commander le premier transistor $PS_H$ en régime linéaire, et ayant un premier noeud d'entrée Ido1_e1 connecté au troisième noeud 103, un deuxième noeud d'entrée Ido1_e5 connecté au noeud de sortie s_rmp du générateur de rampes RMP, et un noeud de sortie Ido1_s connecté à la grille du premier transistor $PS_H$ à travers un premier interrupteur i1. Le premier circuit de régulation linéaire LDO1 forme une boucle de rétroaction analogique adaptée à commander le transistor $PS_H$ en régime linéaire pour contrôler la tension d'alimentation de sortie VCORE fournie sur le noeud 103. Dans l'exemple représenté, le circuit de régulation LDO1 comprend un noeud d'entrée Ido1_e5 pour recevoir une rampe de tension VCTRL à reporter sur le noeud 103. Le circuit LDO1 est apte à ajuster le signal de commande appliqué, via son noeud Ido1_s, sur la grille du transistor $PS_H$ (correspondant à VGATE_$PS_H$ lorsque l'interrupteur i1 est passant). Cela permet d'asservir la tension d'alimentation de sortie

VCORE sur la rampe de tension VCTRL.

Dans cet exemple, le circuit de régulation LDO1 comprend en outre un noeud d'entrée Ido1_e4 pour recevoir un signal d'activation EN_LDO1 du circuit LDO1. Il comprend en outre un noeud d'entrée Ido1_ e3 pour recevoir un signal SWON1 de maintien à l'état fermé (passant) du transistor $PS_H$ suite à une transition montante , et un noeud d'entrée Ido1_e2 pour recevoir un signal SWOFF1 de maintien à l'état ouvert (bloqué) du transistor $PS_H$ suite à une transition descendante. Le circuit de régulation LDO1 comprend en outre un noeud d'alimentation Ido1_p relié au noeud de fourniture de la tension d'alimentation interne VMAX INT.

Le second circuit de gestion de transition $CGT_L$ est configuré pour commander la grille du second transistor $PS_L$ lors de la transition montante ou descendante lorsque l'interrupteur i3 est passant de manière à appliquer un signal de commande $VGATE\_PS_L$ présentant une variation graduelle. A titre d'exemple, une variation de tension graduelle est une variation au cours de temps pouvant être modélisée selon une loi logarithmique $\ln(x)$, une loi linéaire avec une pente lente ($<1V/\mu s$ en valeur absolue), ou une loi exponentielle $\exp(-x)$ avec $x>0$.

Dans l'exemple illustré, le second circuit de gestion de transition $CGT_L$ comprend un circuit de transition graduelle note TR_GR2 apte à réaliser la fonction de commande graduelle du transistor $PS_L$ via un interrupteur i4. L'interrupteur i4 est fermé lorsque au moins l'un des signaux CONTROLLED_SWOFF2 ou CONTROLLED_SWON2 est activé. Pour réaliser le contrôle de l'interrupteur i4, une cellule logique réalisant la fonction "OU" est utilisée. Pour obtenir la variation graduelle sur le noeud $VGATE\_PS_L$ il est possible d'utiliser une résistance ou un élément capacitif.

Avantageusement, le second circuit de gestion de transition $CGT_L$ comprend un second circuit de régulation linéaire LDO2 pour commander le second transistor $PS_L$ en régime linéaire pendant les transitions montante et descendante entre $VDD_L$ et la masse électrique lors d'une mise en veille du noyau $CORE_j$ associé au circuit de sélection $VS_j$. Le second circuit de régulation linéaire LDO2 a un premier noeud d'entrée Ido2_e1 connecté au troisième noeud 103, un deuxième noeud d'entrée Ido2_e5 connecté au noeud de sortie s_rmp du générateur de rampes RMP, et un noeud de sortie Ido2_s connecté à la grille du second transistor $PS_L$ à travers un interrupteur commandé i3. Le second circuit de régulation linéaire LDO2 forme une boucle de rétroaction analogique adaptée à commander le transistor $PS_L$ en régime linéaire pour contrôler la tension d'alimentation de sortie VCORE fournie sur le noeud 103. Dans l'exemple représenté, le circuit de régulation LDO2 comprend un noeud d'entrée Ido2_e5 pour recevoir une rampe de tension VCTRL à reporter sur le noeud 103 lorsqu'il est activé par le signal EN_LDO2. Le circuit LDO2 est apte à ajuster le signal de commande appliqué, via son noeud Ido2_s, sur la grille du transistor $PS_H$ (correspondant à $VGATE\_PS_L$ lorsque l'interrupteur i3 est passant). Cela permet d'asservir la tension d'alimentation de sortie VCORE sur la rampe de tension VCTRL.

Dans cet exemple, le circuit de régulation LDO2 comprend en outre un noeud d'entrée Ido2_e4 pour recevoir le signal d'activation EN_LDO2 du circuit LDO2. Il comprend en outre un noeud d'entrée Ido2_ e3 pour recevoir un signal SWON2 de maintien à l'état fermé (passant) du transistor $PS_L$ suite à une transition descendante, et un noeud d'entrée Ido2_e2 pour recevoir un signal SWOFF2 de maintien à l'état ouvert (bloqué) du transistor $PS_L$ suite à une transition montante. Le circuit de régulation LDO2 comprend en outre un noeud d'alimentation Ido2_p relié au noeud de fourniture de la tension d'alimentation interne VMAX INT.

Le circuit de génération de rampe RMP comprend un noeud de sortie s_rmp connecté aux noeuds d'entrée Ido1_e5 et Ido2_e5 des circuits de régulation linéaire LDO1 et LDO2 et fournissant la rampe de tension VCTRL appliquée aux circuits LDO1 et LDO2. Dans l'exemple représenté, le circuit RMP comprend un noeud d'entrée e1_rmp destiné à recevoir un signal de commande CTRLUP et un noeud d'entrée e2_rmp destiné à recevoir un signal de commande CTRLDW. Lorsque le signal de commande CTRLUP est activé, le circuit RMP est configuré pour générer sur son noeud de sortie s_rmp une rampe de tension croissante prédéterminée. Lorsque le signal de commande CTRLDW est activé, le circuit RMP est configuré pour générer sur son noeud s_rmp une rampe de tension décroissante prédéterminée. Le circuit RMP comprend en outre un noeud d'entrée e3_rmp destiné à recevoir un signal de commande FAST_RMP et un noeud d'entrée e4_rmp destiné à recevoir un signal de commande SLOW_RMP. Lorsque le signal de commande SLOW_RMP est activé, le circuit RMP est configuré pour générer sur son noeud de sortie s_rmp une rampe de tension ayant une première pente prédéterminée pour obtenir une rampe lente. Lorsque le signal de commande FAST_RMP est activé, le circuit RMP est configuré pour générer sur son noeud de sortie s_rmp une rampe de tension ayant une seconde pente largement inférieure en valeur absolue à la première pente pour obtenir une rampe rapide. A titre illustratif, une rampe lente a une pente croissante ou décroissante inférieure en valeur absolue à $1V/\mu s$. Pour la rampe rapide, la valeur absolue de la seconde pente est comprise entre 5 à 10 fois la valeur absolue de la pente lente. De plus, le circuit RMP comprend un noeud d'alimentation p_rmp connecté au noeud de fourniture de la tension d'alimentation interne VMAX_INT. La réalisation du circuit de génération de rampes de tension RMP n'a pas été détaillée, les modes de réalisation décrits étant compatibles avec tous ou la plupart des circuits de génération de rampes de tension connues.

Le circuit de génération de délai DEL comprend un noeud d'entrée e1_del destiné à recevoir un signal d'activation EN_DELAY, et un noeud de sortie s_del. Le circuit DEL est destiné à fournir, sur son noeud de sortie s_del, un signal DELAY_OK présentant une impulsion après un délai prédéterminé. Plus particulièrement, le circuit DEL est destiné à reproduire sur sa sortie s_del, avec un retard prédéterminé, un changement d'état du signal DELAY_OK appliqué sur son noeud d'entrée e1_del. De plus, le circuit DEL comprend en outre un noeud d'alimentation p au noeud de fourniture de la tension d'alimentation interne VMAX_INT. La réalisation du circuit de génération de retard DEL n'a pas été détaillée, les modes de réalisation décrits étant compatibles avec tous ou la plupart des circuits de génération de retard connus.

Le comparateur de tension VCMP présente une première borne d'entrée e- et une seconde borne d'entrée e+. La première borne d'entrée e- est connectée d'une part au noeud 103 d'application de la tension d'alimentation de sortie VCORE par l'intermédiaire d'un interrupteur K4, et d'autre part au noeud 102 d'application de la tension d'alimentation d'entrée basse $VDD_L$ par l'intermédiaire d'un interrupteur K3. +. La seconde borne d'entrée e+ est connectée d'une part au noeud 103 d'application de la tension d'alimentation de sortie VCORE par l'intermédiaire d'un interrupteur K2, et d'autre part au noeud 101 d'application de la tension d'alimentation d'entrée basse $VDD_H$ par l'intermédiaire d'un interrupteur K1. Le comparateur de tension VCMP comprend un noeud de sortie s_cmp et il est destiné à fournir, sur ce noeud s_cmp, une tension VCOVVDD changeant de niveau lorsque la tension appliquée sur son noeud d'entrée e+ atteint un seuil prédéterminé dépendant de celui de la tension appliquée sur son noeud d'entrée e-. Lorsque les interrupteurs K4 et K1 sont fermés (état passant), et les interrupteurs K3 et K2 sont ouverts (état bloquant), le comparateur VCMP compare la tension d'alimentation de sortie VCORE à un premier seuil $V_{seuil1}$ égal à $VDD_L+\Delta V$ avec $\Delta V > 0$. Lorsque les interrupteurs K4 et K1 sont ouverts (état bloquant), et les interrupteurs K3 et K2 sont fermés (état passant), le comparateur VCMP compare la tension d'alimentation de sortie VCORE à un second seuil $V_{seuil2}$ égal à $VDD_H-\Delta V$ avec $\Delta V > 0$. Ainsi, le comparateur VCMP permet de détecter le passage de la tension d'alimentation de sortie VCORE à une valeur inférieure au premier seuil $V_{seuil1} = VDD_L+\Delta V$, mais aussi de détecter le passage de la tension d'alimentation de sortie VCORE à une valeur supérieure au second seuil $V_{seuil2} = VDD_H-\Delta V$ selon la configuration des interrupteurs K1, K2, K3 et K4. Le comparateur de tension VCMP comprend en outre un noeud d'alimentation p connecté au noeud de fourniture de la tension d'alimentation interne VMAX_INT. La réalisation du circuit de comparaison de tension VCMP n'a pas été détaillée, les modes de réalisation décrits étant compatibles avec tous ou la plupart des circuits de comparaison de tension connus.

Dans cet exemple, le circuit de séquencement asynchrone (sans horloge) FSM, met en oeuvre une machine à états finis. Le circuit de séquencement FSM comporte :

- un noeud de sortie s1_fsm connecté au noeud d'entrée e2_rmp du générateur de rampe RMP pour fournir le signal de commande CTRLDW ;

- un noeud de sortie s2_fsm connecté au noeud d'entrée e1_rmp du générateur de rampe RMP pour fournir le signal de commande CTRLUP ;

- un noeud de sortie s3_fsm connecté au noeud d'entrée e4_rmp de générateur de rampe RMP pour fournir le signal de commande SLOW_RMP ;

- un noeud de sortie s4_fsm connecté au noeud d'entrée e3_rmp de générateur de rampe RMP pour fournir le signal de commande FAST_RMP ;

- un noeud de sortie s5_fsm connecté au noeud d'en- trée ldo1_e3 du circuit de régulation linéaire LDO1 pour fournir le signal de commande SWON1 ;

- un noeud de sortie s6_fsm connecté au noeud d'en- trée ldo1_e2 du circuit de régulation linéaire LDO1 pour fournir le signal de commande SWOFF1 ;

- un noeud de sortie s7_fsm connecté au noeud d'en- trée ldo2_e3 du circuit de régulation linéaire LDO2 pour fournir le signal de commande SWON2 ;

- un noeud de sortie s8_fsm connecté au noeud d'en- trée ldo2_e2 du circuit de régulation linéaire LDO2 pour fournir le signal de commande SWOFF2 ;

- un noeud de sortie s9_fsm connecté au noeud d'en- trée ldo2_e4 du circuit de régulation linéaire LDO2 pour fournir le signal de commande EN_LDO2 et à l'interrupteur i3 ;

- un noeud de sortie s10_fsm connecté au noeud d'en- trée ldo1_e4 du circuit de régulation linéaire LDO1 pour fournir le signal de commande EN_LDO1 ;

- un noeud de sortie s1 1_fsm connecté au noeud d'entrée tr2_e1 du circuit de transition graduelle TR_GR2 pour fournir le signal de commande CONTROLLED_SWOFF2 ;

- un noeud de sortie s12_fsm connecté au noeud d'entrée tr2_e2 du circuit de transition graduelle TR_GR2 pour fournir le signal de commande CONTROLLED_SWON2 ;

- un noeud de sortie s13_fsm connecté au noeud d'entrée e1_del du circuit générateur de délai DEL pour fournir le signal de commande EN_DELAY ;

- un noeud de sortie s14_fsm au noeud d'entrée e1_cmp du circuit comparateur VCMP pour fournir le signal de commande EN_VCMP ;

- un noeud de sortie s15_fsm connecté à la grille du transistor SWPG1 pour fournir le signal de commande de EN_SWPG1 ;

- un noeud de sortie s16_fsm connecté à la grille du transistor SWPG2 pour fournir le signal de commande de EN_SWPG2 ;

- un noeud de sortie s17_fsm connecté à la grille du transistor SWPGVMAX pour fournir le signal de commande EN_SWPGVMAX ;

- un noeud d'entrée e1_fsm connecté au noeud de sortie s_cmp du comparateur de tension VCMP pour recevoir la tension de sortie VCOVVDD du comparateur VCMP ;

- et un noeud d'entrée e2_fsm connecté au noeud de sortie s_del du circuit générateur de délai DEL pour recevoir la tension de sortie DELAY_OK du circuit DEL.

Dans l'exemple représenté, le circuit de séquencement FSM comprend en outre une entrée de commande 310 sur un ou plusieurs bits (DIGBUS[1:x]) permettant de commander le circuit de sélection de tension dans la première configuration (transistor $PS_H$ et $PS_L$ respectivement fermé et ouvert) ou dans la seconde configuration (transistor $PS_H$ et $PS_L$ respectivement ouvert et fermé), et, le cas échéant, de configurer certains paramètres du circuit de configuration CONF. Le circuit de séquencement FSM comprend en outre un noeud d'alimentation p1_fsm connecté au noeud de fourniture de la tension d'alimentation interne VMAX_INT. Dans cet exemple, le circuit de séquencement FSM comprend en outre un noeud d'alimentation p2_fsm connecté au noeud de fourniture de la tension d'alimentation VANA. La réalisation du circuit de séquencement FSM n'a pas été détaillée, la réalisation d'un tel circuit étant à la portée de l'homme du métier à partir des indications fonctionnelles décrites dans la présente demande.

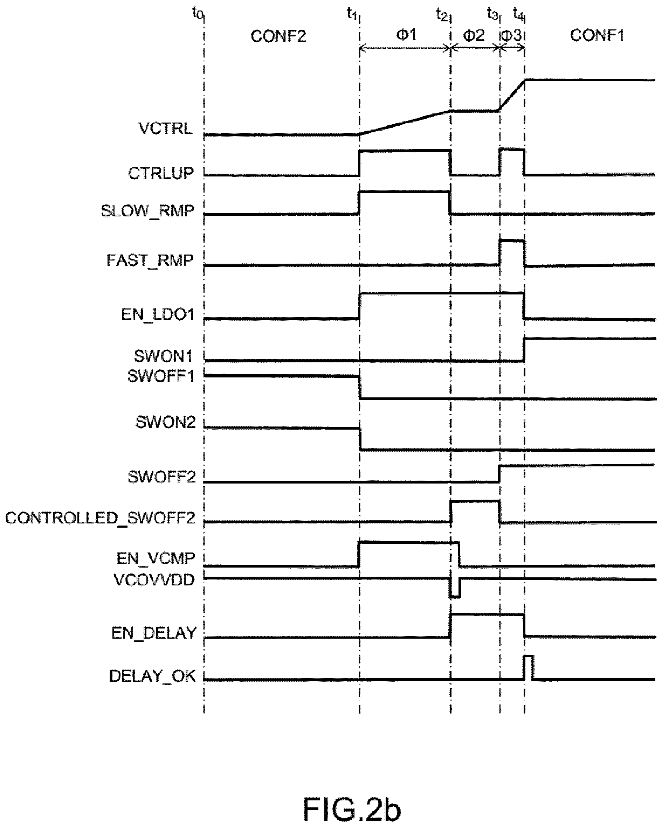

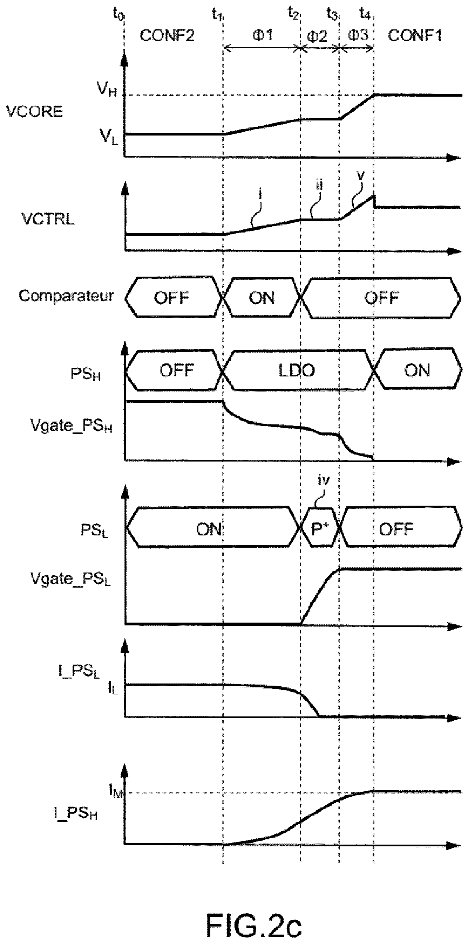

La figure 2b illustre un chronogramme présentant un exemple d'un mode de fonctionnement pendant une transition montante du circuit selon le premier mode de réalisation de la figure 2a. La figure 2c illustre un schéma fonctionnel présentant le mode de fonctionnement du circuit de sélection $VS_j$ du premier mode de réalisation pendant une transition montante.

Les références t0, t1, t2, t3 et t4 sont communs aux figures 2b et 2c. La figure 2b illustre la séquence de quelques signaux de contrôle du circuit de sélection permettant d'obtenir le fonctionnement dudit circuit tel qu'illustré sur la figure 2c. Nous rappelons qu'il s'agit d'une transition montante et donc le système évolue de la seconde configuration CONF2 vers la première configuration CONF1. Par souci de simplification, on se contente sur la figure 2b par représenter les signaux suivants qui présentent des variations pendant la transition montante selon l'invention : le signal de rampe de tension VCTRL en analogique, et les signaux de contrôle en binaire à savoir CTRLUP, SLOW_RMP, FAST_RMP, EN_LDO1, SWON1, SWOFF1, SWON2, SWOFF2, CONTROLLED_SWOFF2, EN_VCMP, VCOVVDD, EN_DELAY, et DELAY_OK . Pendant toute la transition montante, l'interrupteur i1 est maintenu fermé, les interrupteurs K1 et K4 sont maintenus fermés et les interrupteurs K2 et K3 ouverts de manière à comparer VCORE avec le second seuil $V_{seuil2}$ égal à VDDH-$\Delta$V avec $\Delta$V>0.

A l'instant t0, le circuit de sélection VSj est dans un état correspondant à la seconde configuration CONF2 où le circuit de configuration CONF maintient les premier et deuxième transistors $PS_H$ et $PS_L$ respectivement en état bloquant et passant de façon à appliquer la seconde tension d'alimentation d'entrée $VDD_L$ sur le troisième noeud 103. Les signaux CTRLUP, SLOW_RMP, FAST_RMP, EN_LDO1, CONTROLLED_SWOFF2, EN_VCMP, VCOVVDD, EN_DELAY, et DELAY_OK sont à un état bas (désactivé) puisque le système est dans un état stationnaire à cet instant. Les signaux SWON1, SWOFF1 sont respectivement à un état bas (désactivé) et haut (activé) pour maintenir le transistor $PS_H$ à l'état bloquant. Comme on peut observer sur la figure 2c, la tension de grille du transistor $PS_H$ VGATE_$PS_H$ à un niveau haut, le transistor $PS_H$ à l'état bloquant et le courant I_ $PS_H$ à travers $PS_H$ est nul ou quasi nul. Les signaux SWOFF2, SWON2 sont respectivement à un état bas (désactivé) et haut (activé) pour maintenir le transistor $PS_L$ à l'état passant. Comme on peut observer sur la figure 2c, la tension de grille du transistor $PS_L$ VGATE_$PS_L$ à un niveau bas, le transistor $PS_L$ à l'état passant et le courant I_ $PS_L$ à travers $PS_L$ est égal à $I_L$ >0.

A l'instant t1, la première phase $\phi$1 de la transition montante est déclenchée. Le passage des signaux de commande du générateur de rampe CTRUP et SLOW_RMP à un état haut, active la génération d'une rampe de tension croissante ayant une pente lente prédéterminée. On observe l'allure de la rampe sur le signal VCTRL. Simultanément, puisqu'il s'agit d'un état transitoire de l'ensemble du système, les signaux de maintien SWOFF1, SWON1, SWOFF2 et SWON2 passent tous à un état bas. Le signal d'activation du circuit comparateur EN_CMP passe aussi à un état haut mettant ainsi le comparateur en marche pendant $\phi$1. Le signal d'activation EN_LDO1 met en marche le premier circuit de régulation linéaire LDO1 de manière à commander le premier transistor $PS_H$ en régime linéaire pour appliquer la rampe de tension lente VCTRL_sur le troisième noeud 103 durant la phase lente $\phi$1 comme c'est indiqué sur l'évolution de la tension d'alimentation de sortie VCORE sur la figure 2c. Cette évolution de VCORE selon une pente lente (< 1V/$\mu$s) permet de minimiser la variation du courant I_ $PS_H$ à travers $PS_H$ au court du temps permettant ainsi de résoudre le problème de bruit de commutation générés par les variations de tension proportionnelles d (I_ $PS_H$)/dt aux bornes des inductances parasites des rails d'alimentations.

A l'instant t2, le comparateur VCMP détecte le passage de la tension d'alimentation de sortie au-delà de la tension seuil $V_{seuil2}$ égal à $VDD_H-\Delta V$ avec $\Delta V>0$. Le comparateur VCMP génère ainsi une impulsion descendante via le signal de sortie VCOVVDD. Suite à cette détection, la phase suivante $\phi2$ est déclenchée avec le passage du signal SLOW_RMP et du signal CTRUP à un état bas (désactivé) arrêtant ainsi la génération de la rampe à pente lente sur le signal VCTRL et ainsi la tension d'alimentation de sortie VCORE via l'asservissement réalisé par le circuit LDO1 toujours activé. Ainsi, le signal VCTRL (et donc VCORE) sont maintenus à une tension constante comme indiqué dans la figure 2c pendant la durée prédéterminée entre t2 et t3. Cette durée prédéterminée définit alors une phase intermédiaire constante $\phi2$ où la transition du transistor $PS_H$ d'un état bloquant à un état passant est mise en pause. D'un autre côté, pendant la phase constante $\phi2$, le signal CONTROLLED_SWOFF2 passe à un état haut activant ainsi le circuit de transition graduelle TR_GR2. Ainsi, le circuit de transition graduelle TR_GR2 applique, pendant la phase intermédiaire $\phi2$, un signal de commande VGATE_$PS_L$ présentant une variation graduelle sur la grille du second transistor $PS_L$ pour basculer graduellement le second transistor $PS_L$ à un état bloquant tel que représenté dans les diagrammes, VGATE_$PS_L$ (tension sur la grille $PS_L$) de I_$PS_L$ (courant à travers $PS_L$) de la figure 2c. L'interrupteur i4 est fermé pendant toute la phase intermédiaire $\phi2$. La fermeture graduelle et contrôlée en tension et en courant du transistor $PS_L$ permet ainsi de résoudre le problème de bruit de commutation générés par les variations de tension proportionnelles d (I_$PS_L$)/dt aux bornes des inductances parasites des rails d'alimentations. De plus, la mise en pause de la fermeture du transistor $PS_H$ pendant phase intermédiaire $\phi2$ permet d'éliminer la possibilité d'avoir un moment lors de la transition où les deux transistors $PS_L$ et $PS_H$ sont passants en même temps. On élimine ainsi, tout risque de problème de courants inverses.

Suite à la détection du passage de la tension d'alimentation de sortie au-delà de la tension seuil $V_{seuil2}$ le circuit comparateur VCMP est mis à l'arrêt via le signal EN_VCMP pour limiter la consommation globale du circuit. De plus, le circuit de génération de délai est activé via le signal EN_DELAY pour commencer à compter le délai prédéfini pour le reste de la transition montante.

A l'instant t3, le transistor $PS_L$ basculé totalement dans un état bloquant comme illustré sur la figure 2c où le courant I_$PS_L$ est nul ou quasi-nul. Ainsi, la fermeture du transistor $PS_H$ est reprise et la phase $\phi3$ est déclenchée. Ainsi à t3, le passage des signaux de commande du générateur de rampe CTRUP et FAST_RMP à un état haut active la génération d'une rampe de tension croissante ayant une pente rapide prédéterminée. On observe l'allure de la rampe sur le signal VCTRL. Le signal d'activation EN_LDO1 maintient toujours en marche le premier circuit de régulation linéaire LDO1 de manière à commander le premier transistor $PS_H$ en régime linéaire pour appliquer la rampe de tension rapide VCTRL_sur le troisième noeud 103 durant la phase rapide $\phi3$ comme c'est indiqué sur l'évolution de la tension d'alimentation de sortie VCORE sur la figure 2c qui atteint la valeur de tension d'alimentation haute $VDD_H$. La phase rapide $\phi3$ permet de finaliser la transition montante dans un délai réduit de manière à garder toujours une vitesse de transition d'une tension d'alimentation à une autre tout en réduisant les perturbations de bruit de commutation inductive. En effet, le point de départ de la tension VCORE à t3 est proche de la tension d'alimentation cible $VDD_H$, ainsi l'appel de courant à travers I_$PS_H$ est réduit comme illustré dans la figure 2c d'où la réduction du bruit même avec une pente rapide à la fin de la transition.

A t4, le circuit de génération de délai préalablement activé génère via le signal DELAY_OK une impulsion indiquant que la durée prédéterminée prévue pour l'ensemble des phases $\phi2$ et $\phi3$ s'est écoulé. Cela correspond à la fin de la transition montante et le passage à la première configuration CONF1. Les signaux CTRLUP, SLOW_RMP, FAST_RMP, EN_LDO1, CONTROLLED_SWOFF2, EN_VCMP, VCOVVDD, EN_DELAY, et DELAY_OK sont à un état bas (désactivé) puisque le système est dans un état stationnaire à cet instant. Les signaux SWOFF1, SWON1 sont respectivement à un état bas (désactivé) et haut (activé) pour maintenir le transistor $PS_H$ à l'état passant via l'interrupteur i1 fermé. Comme on peut observer sur la figure 2c, la tension de grille du transistor $PS_H$ VGATE_$PS_H$ à un niveau bas, le transistor $PS_H$ à l'état passant et le courant I_ $PS_H$ à travers $PS_H$ est égal à $I_M>0$. Les signaux SWON2, SWOFF2 sont respectivement à un état bas (désactivé) et haut (activé) pour maintenir le transistor $PS_L$ à l'état bloquant à travers l'interrupteur i3 fermé. Comme on peut observer sur la figure 2c, la tension de grille du transistor $PS_L$ VGATE_$PS_L$ à un niveau haut, le transistor $PS_L$ à l'état bloquant et le courant I_ $PS_L$ à travers $PS_L$ est nul ou quasi nul.

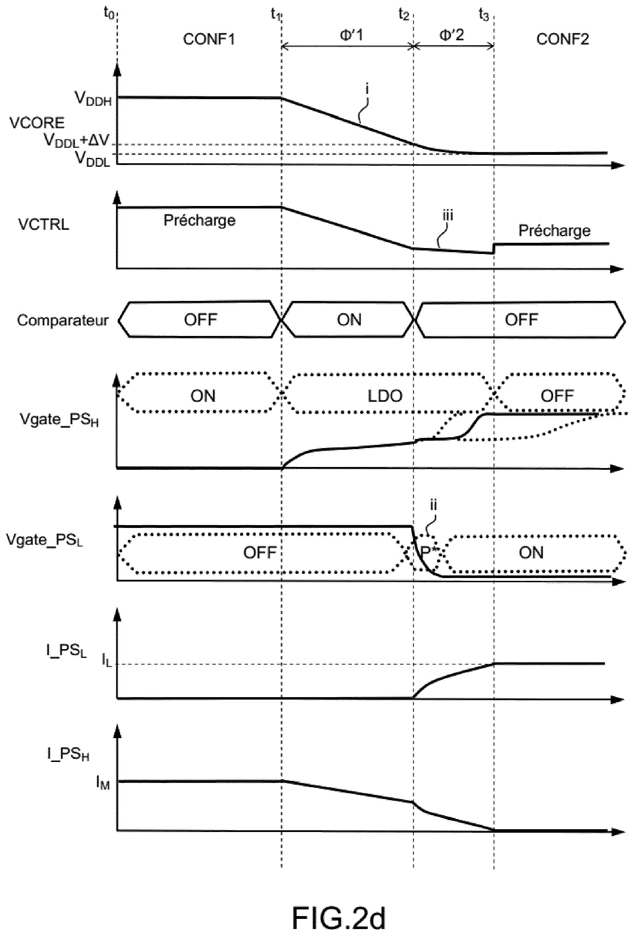

La figure 2d illustre un schéma fonctionnel présentant le mode de fonctionnement du circuit de sélection $VS_j$ du premier mode de réalisation pendant une transition descendante de la tension VCORE de la tension d'alimentation haute $VDD_H$ à la tension d'alimentation basse $VDD_L$. Pendant toute la transition descendante, l'interrupteur i1 est maintenu fermé, les interrupteurs K3 et K2 sont maintenus fermés et les interrupteurs K1 et K4 ouverts de manière à comparer VCORE avec le second seuil $V_{seuil1}$ égal à $VDD_L+\Delta V$ avec $\Delta V>0$.

A l'instant t0, le circuit de sélection $VS_j$ est dans un état correspondant à la première configuration CONF1 où le circuit de configuration CONF maintient les premier et deuxième transistors $PS_H$ et $PS_L$ respectivement en état passant et bloquant de façon à appliquer la tension d'alimentation d'entrée haute $VDD_H$ sur le troisième noeud 103. Les signaux CTRLDW, SLOW_RMP, FAST_RMP, EN_LDO1, CONTROLLED_SWOFF2, EN_VCMP, VCOVVDD, EN_DELAY, et DELAY_OK sont à un état bas (désactivé) puisque le système est dans un état stationnaire à cet instant. Les signaux SWOFF1, SWON1 sont respectivement à un état bas (désactivé) et haut (activé) pour maintenir le transistor $PS_H$ à l'état passant via l'interrupteur i1 fermé. Comme on peut observer sur la figure 2d, la tension de grille du transistor $PS_H$ VGATE_$PS_H$ à un niveau bas, le transistor $PS_H$ à l'état passant et le courant I_ $PS_H$ à travers $PS_H$ est égal à $I_M$ >0.Les signaux SWON2, SWOFF2 sont respectivement à un état bas (désactivé) et haut (activé) pour maintenir le transistor $PS_L$ à l'état bloquant via l'interrupteur i3 fermé. Comme on peut observer sur la figure 2d, la tension de grille du transistor $PS_L$ VGATE_$PS_L$ est à un niveau haut, le transistor $PS_L$ est à l'état bloquant et le courant I_ $PS_L$ à travers $PS_L$ est nul ou quasi nul.

A l'instant t1, la première phase φ'1 de la transition descendante est déclenchée. Le passage des signaux de commande du générateur de rampe CTRDW et FAST_RMP à un état haut active la génération d'une rampe de tension décroissante ayant une pente rapide prédéterminée. On observe l'allure de la rampe sur le signal VCTRL. Simultanément, puisqu'il s'agit d'un état transitoire de l'ensemble du système, les signaux de maintien SWOFF1, SWON1, SWOFF2 et SWON2 passent tous à un état bas . Le signal d'activation du circuit comparateur EN_CMP passe aussi à un état haut mettant ainsi le comparateur est en marche pendant φ'1. Le signal d'activation EN_LDO1 met en marche le premier circuit de régulation linéaire LDO1 de manière à commander le premier transistor $PS_H$ en régime linéaire pour appliquer la rampe de tension rapide VCTRL_sur le troisième noeud 103 durant la phase rapide φ'1 comme c'est indiqué sur l'évolution de la tension d'alimentation de sortie VCORE sur la figure 2d.

A l'instant t2, le comparateur VCMP détecte le passage de la tension d'alimentation de sortie à une valeur inférieure à la tension seuil $V_{seuil1}$ égale à $VDD_L$+ΔV avec ΔV>0. Le comparateur VCMP génère ainsi une impulsion via le signal de sortie VCOVVDD. Suite à cette détection, la phase suivante φ'2 est déclenchée avec le passage du signal FAST_RMP un état bas (désactivé) et le passage du signal SLOW_RMP à un état haut permettant ainsi la génération de la rampe à pente lente sur le signal VCTRL et ainsi sur la tension d'alimentation de sortie VCORE via l'asservissement réalisé par le circuit LDO1 toujours activé. Ainsi, le signal VCTRL (et donc VCORE) suivent une rampe décroissante lente comme indiqué dans la figure 2d pendant la durée prédéterminée entre t2 et t3. D'un autre côté, pendant la phase lente φ'2, le signal CONTROLLED_SWON2 passe à un état haut activant ainsi le circuit de transition graduelle TR_GR2. Ainsi, le circuit de transition graduelle TR_GR2 applique, pendant la phase intermédiaire φ'2, un signal de commande VGATE_$PS_L$ présentant une variation décroissante graduelle sur la grille du second transistor $PS_L$ pour basculer graduellement le second transistor $PS_L$ à un état passant tel que représenté dans les digrammes, VGATE_$PS_L$ (tension sur la grille $PS_L$) de I_$PS_L$ (courant à travers $PS_L$) de la figure 2d. L'interrupteur i4 est fermé pendant toute la phase lente φ'2. La fermeture graduelle et contrôlée en tension et en courant du transistor $PS_L$ permet ainsi de résoudre le problème de bruit de commutation générés par les variations de tension proportionnelles d (I_ $PS_L$)/dt aux bornes des inductances parasites des rails d'alimentations. De plus, le déclenchement retardé de la fermeture du transistor $PS_L$ pendant phase intermédiaire φ'2 permet d'éliminer la possibilité d'avoir un moment lors de la transition où les deux transistors $PS_L$ et $PS_H$ sont intégralement passants en même temps. On élimine ainsi, tout risque de problème de courants inverses.

Suite à la détection du passage de la tension d'alimentation de sortie au-delà de la tension seuil $V_{seuil1}$ le circuit comparateur VCMP est mis à l'arrêt via le signal EN_VCMP pour limiter la consommation globale du circuit. De plus, le circuit de génération de délai est activé via le signal EN_DELAY pour commencer à compter le délai prédéfini pour la phase lente φ'2 .

A t3, le circuit de génération de délai préalablement activé génère via le signal DELAY_OK une impulsion indiquant que la durée prédéterminée prévue pour la phase φ'2 s'est écoulé. Cela correspond à la fin de la transition descendante et le passage à la seconde configuration CONF2. Les signaux CTRLUP, SLOW_RMP, FAST_RMP, EN_LDO1, CONTROLLED_SWOFF2, EN_VCMP, VCOVVDD, EN_DELAY, et DELAY_OK sont à un état bas (désactivé) puisque le système est dans un état stationnaire à cet instant. Les signaux SWON1, SWOFF1 sont respectivement à un état bas (désactivé) et haut (activé) pour maintenir le transistor $PS_H$ à l'état bloquant via l'interrupteur i1 fermé. Comme on peut observer sur la figure 2c, la tension de grille du transistor $PS_H$ VGATE_$PS_H$ à un niveau haut, le transistor $PS_H$ à l'état bloquant et le courant I_ $PS_H$ à travers $PS_H$ est nul ou quasi nul. Les signaux SWON2, SWOFF2 sont respectivement à un état haut (activé) et bas (désactivé) pour maintenir le transistor $PS_L$ à l'état passant avec l'interrupteur i3 fermé. Comme on peut observer sur la figure 2d, la tension de grille du transistor $PS_L$ VGATE_$PS_L$ à un niveau bas, le transistor $PS_L$ à l'état passant et le courant I_ $PS_L$ à travers $PS_L$ est égal à $I_L$ >0.

Le séquencement des étapes décrit précédemment mis en oeuvre par le circuit de sélection de la tension d'alimentation $VS_j$ selon un premier mode de l'invention permet ainsi de réaliser un ajustement dynamique de la tension tout en limitant le bruit de commutation inductif d'alimentation et en évitant le phénomène de courants inverses pour des transitions montantes et descendantes. Sans perte de généralité, et à titre illustratif, nous allons dans la section suivante décrire un second mode de réalisation de l'invention et la configuration associée permettant de résoudre le problème de bruit de commutation inductif.

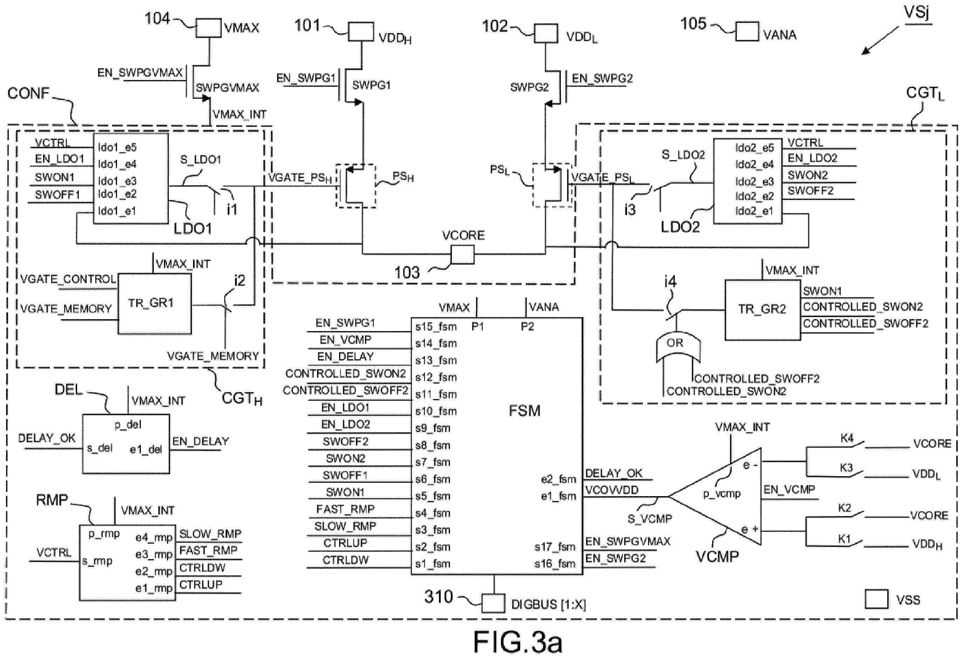

La figure 3a illustre un circuit électronique de sélection d'une tension d'alimentation selon un second mode de réalisation de l'invention.

Le circuit de sélection VS$_j$ selon le second mode de réalisation reprend les mêmes éléments préalablement décrits pour le premier mode de réalisation avec une différence consistant en ce qui suit. Le premier circuit de gestion de transition CGT$_H$ comprend en outre un circuit de transition graduelle TR_GR1 ayant un noeud de sortie gr1_s connecté à la grille du premier transistor PS$_H$ à travers un interrupteur i2. Le premier circuit de transition graduelle TR_GR1 est apte à appliquer un signal de commande VGATE_PS$_H$ présentant une variation graduelle sur la grille du second transistor PS$_L$ lorsque le deuxième interrupteur i2 est passant. L'interrupteur i2 est fermé lorsque le signal VGATE_MEMORY est activé. Le circuit de transition graduelle TR_GR1 reçoit deux signaux d'activation VGATE_MEMORY et VGATE_CONTROL. A titre d'exemple, une variation de tension graduelle est une variation au cours de temps pouvant être modélisée selon une loi logarithmique ln(x), une loi linéaire avec une pente lente (<1V/μs en valeur absolue), ou une loi exponentielle exp(-x) avec x>0. La transition graduelle est obtenue par exemple via la charge et la décharge d'un élément capacitif ayant une borne connectée à la grille VGATE_PS$_H$.

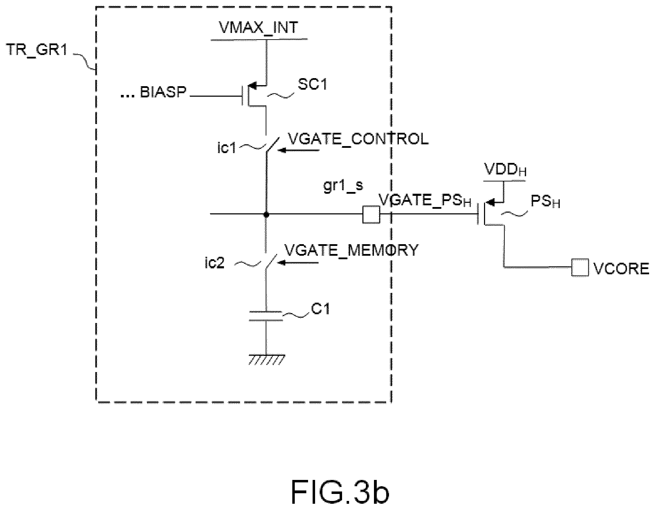

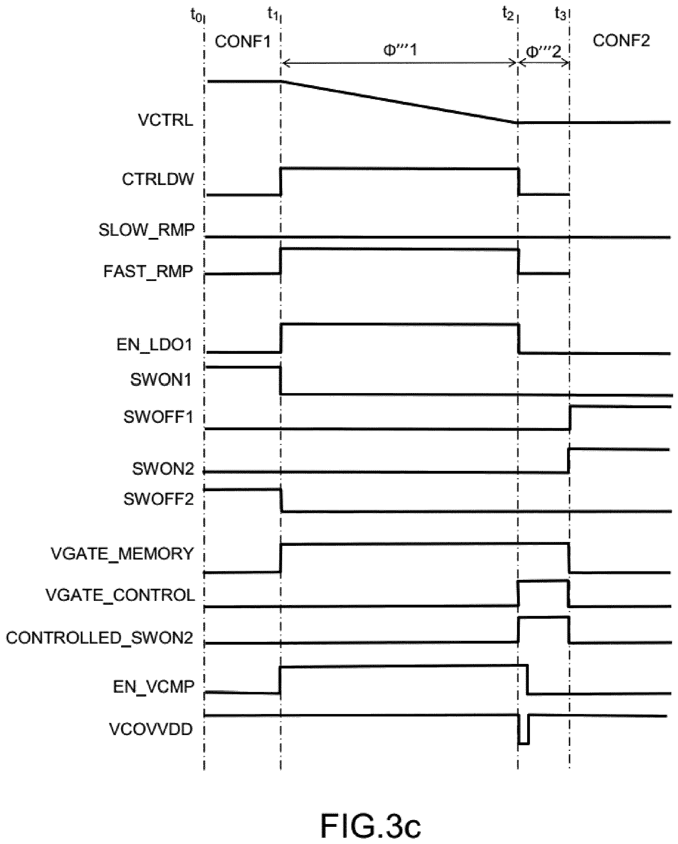

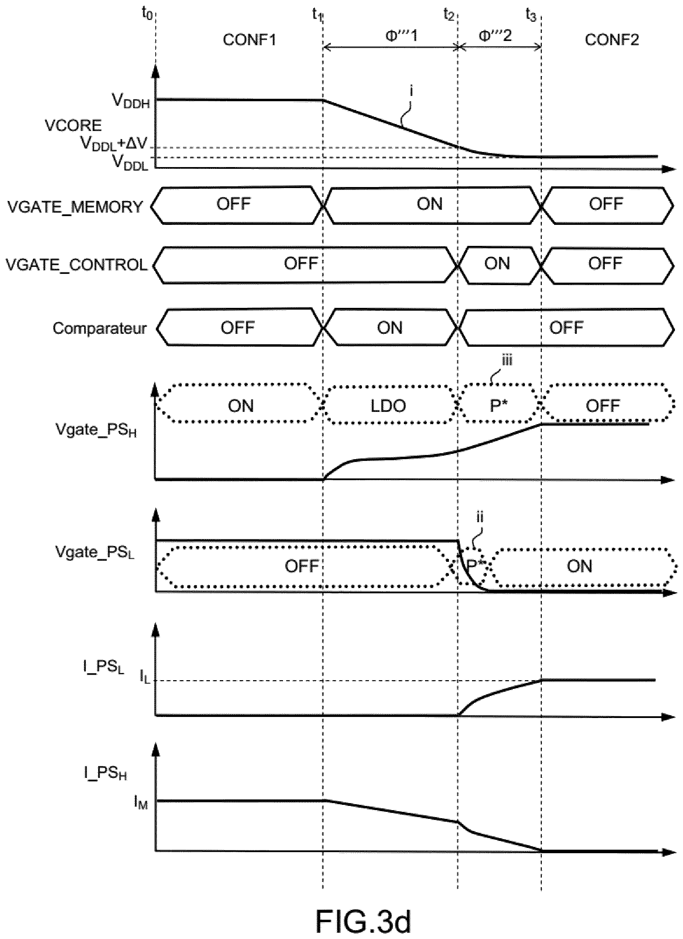

La figure 3b illustre un exemple d'implémentation du circuit de transition graduelle TR_GR1 selon l'invention. Le circuit de transition graduelle TR_GR1 comprend un transistor SC1 de type PMOS commandé par un signal de polarisation BIASP, un interrupteur ic1 commandé par le signal VGATE_CONTROL, un interrupteur ic2 commandé par le signal VGATE_MEMORY, et un élément capacitif C1. La source du transistor SC1 est connectée à la tension d'alimentation interne, le drain est connecté, lorsque l'interrupteur ic1 est passant, au noeud de sortie gr1_s correspondant au signal de commande VGATE_PS$_H$ et la grille est polarisé de manière à réaliser une source de courant. L'interrupteur ic1 est passant lorsque VGATE_CONTROL est activé et bloquant dans le cas inverse. L'interrupteur ic2 est passant lorsque VGATE_MEMORY est activé et bloquant dans le cas inverse. L'élément capacitif C1 est connecté d'une part la masse électrique et d'autre part au noeud de sortie gr1_s correspondant au signal de commande VGATE_PS$_H$ lorsque l'interrupteur i2 est passant. Lorsque VGATE_MEMORY est activé et VGATE_CONTROL est désactivé, l'élément capacitif joue le rôle de point mémoire local du signal VGATE_PS$_H$ collecté sur le noeud de sortie gr1_s. Lorsque les deux signaux VGATE_MEMORY et VGATE_CONTROL sont simultanément activés, l'élément capacitif C1 se charge via la source de courant SC1 de manière à appliquer un signal de commande VGATE_PS$_H$ présentant une variation graduelle sur la grille du premier transistor PS$_H$. Nous rappelons que la courbe de charge d'un condensateur de capacité C au cours du temps t avec un courant I constant est sous la forme $V(t) = \dfrac{It}{C}$. Nous rappelons que la courbe de charge d'un condensateur en série avec une résistance au cours du temps avec un courant constant est sous la forme $V(t) = V_{cmax}(1 - e^{-t/\tau})$ avec $V_{cmax}$ et $\tau$ constants positives.La figure 3c illustre un chronogramme présentant un exemple d'un mode de fonctionnement pendant une transition descendante du circuit selon le second mode de réalisation de la figure 3a. La figure 3d illustre un schéma fonctionnel présentant le mode de fonctionnement du circuit de sélection VS$_j$ du second mode de réalisation pendant une transition descendante.

Les références t0, t1, t2 et t3 sont communs aux figures 3c et 3d. La figure 3c illustre la séquence de quelques signaux de contrôle du circuit de sélection permettant d'obtenir le fonctionnement dudit circuit tel qu'illustré sur la figure 3d. Nous rappelons qu'il s'agit d'une transition descendante et donc le système évolue de la première configuration CONF1 vers la seconde configuration CONF2. Par souci de simplification, on se contente sur la figure 3c par représenter les signaux suivants qui présentent des variations pendant la transition descendante selon l'invention : le signal de rampe de tension VCTRL en analogique, et les signaux de contrôle en binaire à savoir CTRLDW, SLOW_RMP, FAST_RMP, EN_LDO1, SWON1, SWOFF1, SWON2, SWOFF2, VGATE_MEMORY, VGATE_CONTROL, CONTROLLED_SWON2, EN_VCMP, VCOVVDD. Pendant toute la transition descendante, l'interrupteur i1 est maintenu fermé, les interrupteurs K3 et K2 sont maintenus fermés et les interrupteurs K1 et K4 ouverts de manière à comparer VCORE avec le second seuil $V_{seuil1}$ égal à VDD$_L$+ΔV avec ΔV>0.

A l'instant t0, le circuit de sélection VSj est dans un état correspondant à la première configuration CONF1 où le circuit de configuration CONF maintient les premier et deuxième transistors PSH et PSL respectivement en état passant et bloquant de façon à appliquer la tension d'alimentation d'entrée haute VDDH sur le troisième noeud 103. Les signaux CTRLDW, SLOW_RMP, FAST_RMP, EN_LDO1, CONTROLLED_SWOFF2, EN_VCMP, VCOVVDD,VGATE_MEMORY et VGATE_CONTROL sont à un état bas (désactivé) puisque le système est dans un état stationnaire à cet instant. Les signaux SWOFF1, SWON1 sont respectivement à un état bas (désactivé) et haut (activé) pour maintenir le transistor PSH à l'état passant via l'interrupteur i1 fermé. Comme on peut observer sur la figure 2d, la tension de grille du transistor PSH VGATE_PSH à un niveau bas, le transistor PSH à l'état passant et le courant I_ PSH à travers PSH est égal à IM >0. Les signaux SWON2, SWOFF2 sont respectivement à un état bas (désactivé) et haut (activé) pour maintenir le transistor PSL à l'état bloquant via l'interrupteur i3 fermé. Comme on peut observer sur la figure 2d, la tension de grille du transistor PSL VGATE_PSL est à un niveau haut, le transistor PSL est à l'état bloquant et le courant I_ PSL à travers PSL est nul ou quasi nul.

A l'instant t1, la première phase $\phi'''1$ de la transition descendante est déclenchée. Le passage des signaux de commande du générateur de rampe CTRDW et FAST_RMP à un état haut active la génération d'une rampe de tension décroissante ayant une pente rapide prédéterminée. On observe l'allure de la rampe sur le signal VCTRL. Simultanément, puisqu'il s'agit d'un état transitoire de l'ensemble du système, les signaux de maintien SWOFF1, SWON1, SWOFF2 et SWON2 passent tous à un état bas . Le signal d'activation du circuit comparateur EN_CMP passe aussi à un état haut mettant ainsi le comparateur est en marche pendant $\phi'''1$. Le signal d'activation EN_LDO1 met en marche le premier circuit de régulation linéaire LDO1 de manière à commander le premier transistor $PS_H$ en régime linéaire pour appliquer la rampe de tension rapide VCTRL_sur le troisième noeud 103 durant la phase rapide $\phi'''1$ comme c'est indiqué sur l'évolution de la tension d'alimentation de sortie VCORE sur la figure 3c. Simultanément, le signal VGATE_MEMORY est activé pour enregistrer une image de l'évolution du signal VGATE_$PS_H$ dans le point mémoire pour réaliser par le condensateur C1 du circuit de transition graduelle TR_GR1.

A l'instant t2, le comparateur VCMP détecte le passage de la tension d'alimentation de sortie à une valeur inférieure à la tension seuil $V_{seuil1}$ égale à $VDD_L+\Delta V$ avec $\Delta V>0$. Le comparateur VCMP génère ainsi une impulsion via le signal de sortie VCOVVDD. Suite à cette détection, la phase suivante $\phi'''2$ est déclenchée avec le passage des signaux EN_LDO1 et FAST_RMP à un état bas (désactivé) et le passage du signal VGATE_CONTROLLED à un état haut. Comme expliquer précédemment, l'activation simultanée de VGATE_CONTROLLED et VGATE_MEMORY permet ainsi à appliquer un signal de commande VGATE_$PS_H$ présentant une variation croissante graduelle sur la grille du premier transistor $PS_H$. D'un autre côté, pendant la phase lente $\phi'''2$, le signal CONTROLLED_SWON2 passe à un état haut activant ainsi le circuit de transition graduelle TR_GR2. Ainsi, le circuit de transition graduelle TR_GR2 applique, pendant la phase intermédiaire $\phi'''2$, un signal de commande VGATE_$PS_L$ présentant une variation décroissante graduelle sur la grille du second transistor $PS_L$ pour basculer graduellement le second transistor $PS_L$ à un état passant tel que représenté dans les digrammes, VGATE_$PS_L$ (tension sur la grille $PS_L$) de I_$PS_L$ (courant à travers $PS_L$) de la figure 3d. L'interrupteur i4 est fermé pendant toute la phase lente $\phi'''2$. La fermeture graduelle et contrôlée en tension et en courant des transistors $PS_L$ et $PS_H$ permet ainsi de résoudre le problème de bruit de commutation générés par les variations de tension proportionnelles d (I_$PS_L$)/dt et d (I_$PS_H$)/dt aux bornes des inductances parasites des rails d'alimentations. De plus, le déclenchement retardé de la fermeture du transistor $PS_L$ pendant phase intermédiaire $\phi'''2$ permet d'éliminer la possibilité d'avoir un moment lors de la transition où les deux transistors $PS_L$ et $PS_H$ sont intégralement passants en même temps. On élimine ainsi, tout risque de problème de courants inverses.

Suite à la détection du passage de la tension d'alimentation de sortie au-delà de la tension seuil $V_{seuil1}$ le circuit comparateur VCMP est mis à l'arrêt via le signal EN_VCMP pour limiter la consommation globale du circuit. De plus, le circuit de génération de délai est activé via le signal EN_DELAY pour commencer à compter le délai prédéfini pour la phase lente $\phi'''2$.

A t3, le circuit de génération de délai préalablement activé génère via le signal DELAY_OK (non représenté) une impulsion indiquant que la durée prédéterminée prévue pour la phase $\phi'''2$ s'est écoulé. Cela correspond à la fin de la transition descendante et le passage à la seconde configuration CONF2. Les signaux CTRLDW, SLOW_RMP, FAST_RMP, EN_LDO1, CONTROLLED_SWOFF2, EN_VCMP, VCOVVDD, VGATE_MEMORY et VGATE_CONTROL sont à un état bas (désactivé) puisque le système est dans un état stationnaire à cet instant. Les signaux SWON1, SWOFF1 sont respectivement à un état bas (désactivé) et haut (activé) pour maintenir le transistor $PS_H$ à l'état bloquant via l'interrupteur i1 fermé. Comme on peut observer sur la figure 3d, la tension de grille du transistor $PS_H$ VGATE_$PS_H$ à un niveau haut, le transistor $PS_H$ à l'état bloquant et le courant I_ $PS_H$ à travers $PS_H$ est nul ou quasi nul. Les signaux SWON2, SWOFF2 sont respectivement à un état haut (activé) et bas (désactivé) pour maintenir le transistor $PS_L$ à l'état passant avec l'interrupteur i3 fermé. Comme on peut observer sur la figure 3d, la tension de grille du transistor $PS_L$ VGATE_$PS_L$ à un niveau bas, le transistor $PS_L$ à l'état passant et le courant I_ $PS_L$ à travers $PS_L$ est égal à $I_L>0$.

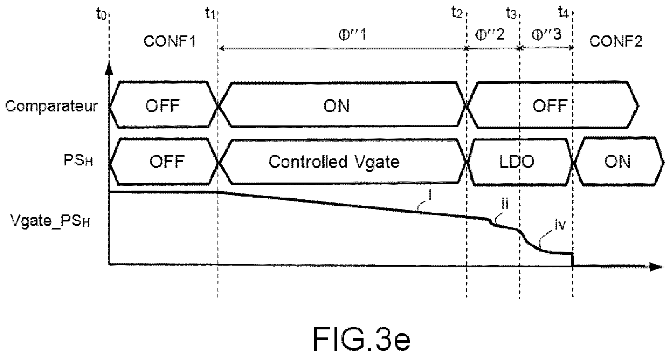

La figure 3e illustre un chronogramme présentant un exemple d'un mode de fonctionnement pendant une transition montante du circuit selon le second mode de réalisation de la figure 3a. Par souci de simplification, on présente uniquement le fonctionnement du premier transistor $PS_H$ qui change par rapport à la transition montante du premier mode de réalisation.

Pendant la phase lente $\phi''1$ (équivalent de la phase lente $\phi1$ du premier mode de réalisation) de la transition montante, le contrôle du signal VGATE_$PS_H$ n'est pas réalisé via l'activation premier circuit de régulation linéaire LDO1 qui reçoit une rampe mais en appliquant directement un signal de commande VGATE_$PS_H$ présentant une variation décroissante graduelle sur la grille du premier transistor $PS_H$ à l'aide du circuit de transition graduelle TR_GR1.

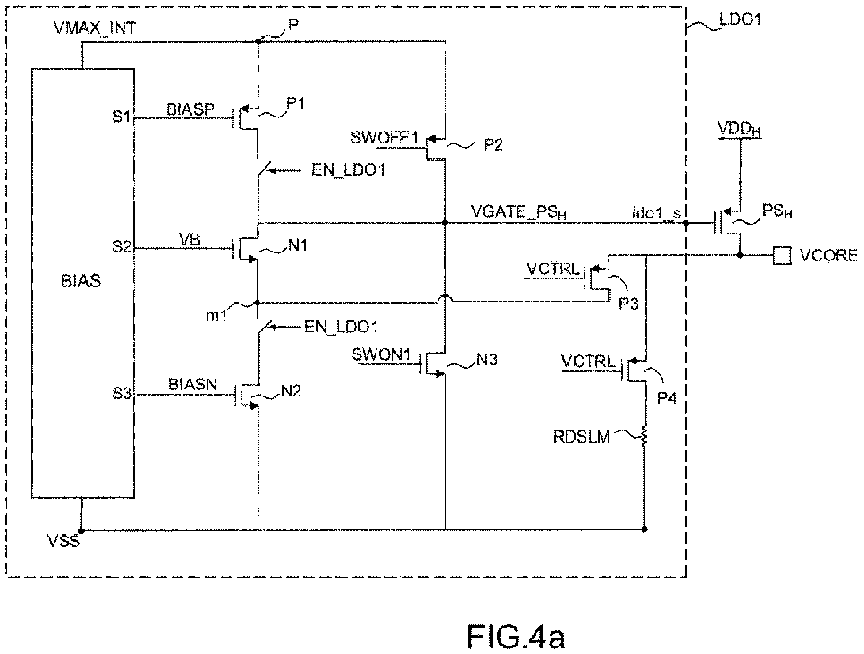

A titre d'exemple, la figure 4a illustre un exemple de réalisation du premier circuit de régulation linéaire de tension LDO1 implémenté circuit de sélection d'une tension d'alimentation selon l'invention.

Le circuit de régulation linéaire de tension LDO1 de la figure 4a comprend un circuit de polarisation BIAS alimenté par la tension VMAX_INT. Le circuit de polarisation BIAS comprend un noeud s1 de fourniture d'une tension de polarisation BIASP, un noeud s2 de fourniture d'une tension de polarisation VB, et un noeud s3 de fourniture d'une tension de polarisation BIASN.

Le circuit LDO1 comprend en outre un transistor P1 de type PMOS reliant, via ses noeuds de conduction, le noeud d'alimentation de la tension VMAX_INT au noeud de sortie de LDO1 noté Ido1_ s, et donc la grille du transistor PS$_H$. La grille du transistor P1 est connectée au noeud de sortie s1 du circuit BIAS pour recevoir le signal de polarisation BIASP. Le circuit LDO1 comprend en outre un transistor N1 de type NMOS reliant, via ses noeud s de conduction, le noeud de sortie Ido1_s du circuit LDO1 à un noeud intermédiaire n1, et un transistor N2 de type N reliant, via ses noeud s de conduction, le noeud n1 à la masse VSS. La grille du transistor N1 est connectée au noeud de sortie s2 du circuit BIAS pour recevoir le signal de polarisation VB, et la grille du transistor N2 est connectée au noeud de sortie s3 du circuit BIAS pour recevoir le signal de polarisation BIASN.

Le circuit LDO1 de la figure 4a comprend de plus un transistor P3 de type PMOS reliant, via ses noeuds de conduction, le noeud de fourniture de la tension VCORE, au noeud interne n1. La grille du transistor P3 est connectée au noeud de fourniture de la tension de rampe VCTRL. Dans cet exemple, le circuit LDO1 comprend en outre un transistor P4 de type PMOS relié en série, via ses noeud s de conduction, avec une résistance RDISLIM, entre le noeud de fourniture de la tension de rampe VCTRL et la masse électrique VSS. La grille du transistor P4 est connectée au noeud d'application de la tension de consigne VCTRL. Le circuit LDO1 de la figure 4a comprend de plus un transistor P2 de type PMOS reliant, via ses noeud s de conduction, le noeud d'alimentation p du circuit LDO1 à son noeud de sortie Ido1_s, et un transistor N3 de type NMOS reliant, via ses noeud s de conduction, le noeud de sortie Ido1_s à la masse électrique VSS. La grille du transistor N3 est connectée au noeud d'application du signal de commande SWON1, et la grille du transistor P2 est par l'inverse logique du signal de commande SWOFF1. L'inverse logique est obtenu par l'intermédiaire d'un inverseur non représenté pour alléger la présentation.

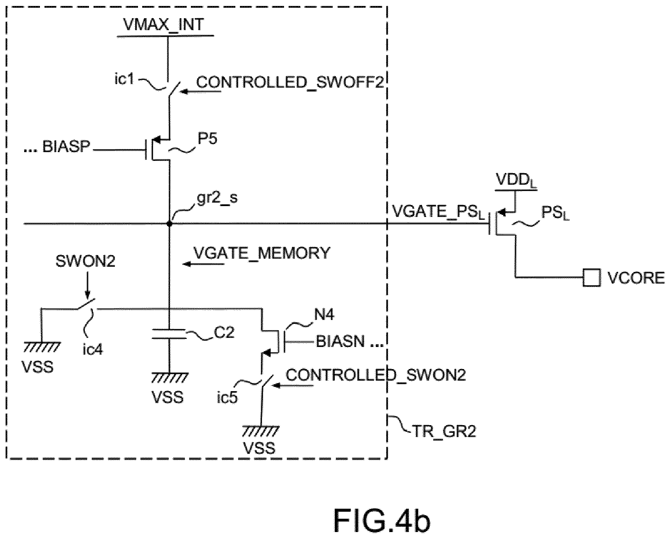

A titre d'exemple, la figure 4b illustre un exemple de réalisation du circuit de transition graduelle TR_GR2 du circuit de sélection d'une tension d'alimentation selon l'invention.

Il s'agit d'un mode de réalisation illustratif et non limitatif, basé sur la charge et la décharge d'un élément capacitif C2 ayant un pôle connecté à la grille du second transistor PS$_L$ qui reçoit le signal VGATE_PS$_L$.

Alternativement, il est possible d'utiliser des résistances pour générer des signaux de contrôle à variation graduelle.

Dans cet exemple de réalisation à base d'élément capacitif, le circuit de transition graduelle TR_GR2 comprend un transistor P5 de type PMOS commandé par un signal de polarisation BIASP, un transistor N4 de type PMOS commandé par un signal de polarisation BIASN, un interrupteur ic3 commandé par l'inverse logique du signal CONTROLLED_SWOFF2, un interrupteur ic4 commandé par le signal SWON2, un interrupteur ic5 commandé par le signal CONTROLLED_SWON2 et un élément capacitif C2. Pour simplifier le circuit on note que les signaux de polarisation BIASP et BIASN sont généré par un circuit de polarisation BIAS commun avec d'autres blocs et non représenté par souci de simplification.

La source du transistor P5 est connectée à la tension d'alimentation interne VMAX_INT lorsque l'interrupteur ic3 est passant et son drain est connecté au noeud de sortie correspondant à la grille de PS$_L$. La grille de P5 est polarisée de manière à réaliser une source de courant. La source du transistor N4 est connectée à la masse VSS lorsque l'interrupteur ic5 est passant et son drain est connecté au noeud de sortie relié à la grille de PS$_L$. La grille de N4 est polarisée de manière à réaliser une source de courant. L'interrupteur ic3 est passant lorsque CONTROLLED_SWOFF2 est activé et bloquant dans le cas inverse. L'interrupteur ic4 est passant lorsque SWON2 est activé et bloquant dans le cas inverse. L'élément capacitif C2 est connecté d'une part la masse électrique et d'autre part au noeud de sortie gr2_s correspondant au signal de commande VGATE_PS$_L$ lorsque l'interrupteur i4 est passant.

Ainsi, pour appliquer un signal présentant une variation croissante graduelle du signal VGATE_PS$_L$, le signal CONTROLLED_SWOFF2 est activé et les autres signaux SWON2, CONTROLEED_SWON2 sont désactivés de manière à charger progressivement l'élément capacitif C2 obtenant ainsi la variation graduelle voulue sur VGATE_PS$_L$.

Pour appliquer un signal présentant une variation croissante graduelle VGATE_PS$_L$, le signal CONTROLLED_SWOFF2 est désactivé et le signal CONTROLEED_SWON2 est activé de manière à décharger progressivement l'élément capacitif C2 à travers la branche de N4 obtenant ainsi la variation graduelle voulue sur VGATE_PS$_L$.

Suite à la fin d'une transition, pour maintenir le signal VGATE_PS$_L$ à un niveau bas (connecté à la masse), il suffit d'activer le signal SWON2 pour fermer l'interrupteur ic4 reliant ainsi VGATE_PS$_L$ à la masse.

**Revendications**

1. Circuit de sélection d'une tension d'alimentation (VS$_j$), comprenant :

   - un premier noeud (101) adapté à recevoir une première tension d'alimentation d'entrée (VDD$_H$) ;
   - un deuxième noeud (102) adapté à recevoir une seconde tension d'alimentation d'entrée (VDD$_L$) inférieure à la première tension d'alimentation d'entrée (VDD$_H$) ;

- un troisième noeud (103) adapté à fournir une tension d'alimentation de sortie (VCORE) ;
- un premier transistor de puissance ($PS_H$) reliant le premier noeud (101) au troisième noeud (103) ;
- un second transistor de puissance ($PS_L$) reliant le deuxième noeud (102) au troisième noeud (103) ;
- et un circuit de configuration (CONF) adapté dans une première configuration, à maintenir les premier ($PS_H$) et deuxième ($PS_L$) transistors respectivement passant et bloquant de façon à appliquer la première tension d'alimentation d'entrée ($VDD_H$) sur le troisième noeud (103), et, dans une seconde configuration, à maintenir les premier ($PS_H$) et deuxième ($PS_L$) transistors respectivement en état bloquant et passant de façon à appliquer la seconde tension d'alimentation d'entrée ($VDD_L$) sur le troisième noeud (103) ;

une phase de transition de la première configuration à la seconde configuration étant dénommée transition descendante ;

une phase de transition de la seconde configuration à la première configuration étant dénommée transition montante ;

le circuit de configuration (CONF) comprenant :

- un premier circuit de gestion de transition ($CGT_H$) configuré pour commander la grille du premier transistor ($PS_H$) lors de la transition montante ou descendante de manière à appliquer sur le troisième noeud (103) :

  ○ au moins une première rampe de tension ayant une première pente pendant une première durée définissant une phase lente ($\phi1$, $\phi'2$, $\phi''1$, $\phi'''2$) ;
  
  ○ et une seconde rampe de tension ayant une seconde pente étant supérieure à la première pente pendant une deuxième durée définissant une phase rapide ($\phi3$, $\phi'1$, $\phi''3$, $\phi'''1$).

- un second circuit de gestion de transition ($CGT_L$) configuré pour commander la grille du second transistor ($PS_L$) lors de la transition montante ou descendante de manière à appliquer un signal de commande (VGATE_$PS_L$) présentant une variation graduelle ;

lors d'une transition montante, la première rampe de tension étant appliquée avant la seconde rampe de tension ; lors d'une transition descendante, la seconde rampe de tension étant appliquée avant la première rampe de tension.

2. Circuit de sélection d'une tension d'alimentation ($VS_j$) selon la revendication 1 dans lequel la valeur absolue de la première pente est comprise entre un dixième de la valeur absolue de la deuxième pente et un cinquième de la valeur absolu deuxième pente.

3. Circuit de sélection d'une tension d'alimentation ($VS_j$) selon l'une quelconque des revendications 1 ou 2 dans lequel le circuit de configuration (CONF), pour réaliser une transition montante, est configuré pour exécuter successivement les étapes suivantes :

vi- commander le premier transistor ($PS_H$) en régime linéaire pour appliquer la première rampe de tension sur le troisième noeud (103) durant la phase lente ($\phi1$) ;

vii- détecter le passage de la tension d'alimentation de sortie (VCORE) à un niveau supérieur à un seuil prédéterminé inférieur à la première tension d'alimentation d'entrée ($VDD_H$), ledit passage indiquant l'achèvement de la phase lente ;

viii- commander le premier transistor ($PS_H$) en régime linéaire pour appliquer une tension constante sur le troisième noeud (103) pendant une phase intermédiaire ($\phi2$) entre la phase lente et la phase rapide ;

ix- et appliquer, pendant la phase intermédiaire ($\phi2$), un signal de commande (VGATE_$PS_L$) présentant une variation graduelle sur la grille du second transistor ($PS_L$) pour basculer graduellement le second transistor ($PS_L$) à un état bloquant ;

x- commander le premier transistor ($PS_H$) en régime linéaire pour appliquer la seconde rampe de tension sur le troisième noeud (103) durant la phase rapide ($\phi3$) jusqu'au passage du premier transistor ($PS_H$) à un état passant.

4. Circuit de sélection d'une tension d'alimentation ($VS_j$) selon l'une quelconque des revendications 1 ou 2 dans lequel le circuit de configuration (CONF), pour réaliser une transition descendante, est configuré pour exécuter successivement les étapes suivantes :

v- commander le premier transistor ($PS_H$) en régime linéaire pour appliquer la seconde rampe de tension sur le troisième noeud (103) durant la phase rapide ($\phi'1$);

vi- détecter le passage de la tension d'alimentation de sortie (VCORE) à un niveau supérieur à un niveau inférieur à un seuil prédéterminé supérieur la seconde tension d'alimentation d'entrée ($VDD_L$), ledit passage indiquant l'achèvement de la phase rapide ($\phi'1$) ;

vii- appliquer, pendant la phase lente ($\phi'2$), un

signal de commande (VGATE_PS$_L$) présentant une variation graduelle sur la grille du second transistor (PS$_L$) pour basculer graduellement le second transistor (PS$_L$) à un état passant;

viii- et commander le premier transistor (PS$_H$) en régime linéaire pour appliquer la première rampe de tension sur le troisième noeud (103) durant la phase lente ($\phi$'2) jusqu'au passage du premier transistor (PS$_H$) à un état bloquant.

5. Circuit de sélection d'une tension d'alimentation (VS$_j$) selon l'une quelconque des revendications 1 ou 2 dans lequel le circuit de configuration (CONF), pour réaliser une transition montante, est configuré pour exécuter successivement les étapes suivantes :

    vi- appliquer un second signal de commande (VGATE_PS$_H$) présentant une variation graduelle sur la grille du premier transistor (PS$_H$) durant la phase lente ($\phi$"1) ;

    vii- détecter le passage de la tension d'alimentation de sortie (VCORE) à un niveau supérieur à un seuil prédéterminé inférieur à la première tension d'alimentation d'entrée (VDD$_H$), ledit passage indiquant l'achèvement de la phase lente ;

    viii- commander le premier transistor (PS$_H$) en régime linéaire pour appliquer une tension constante sur le troisième noeud (103) pendant <u>une phase intermédiaire</u> ($\phi$"2) entre la phase lente et la phase rapide ;

    ix- et appliquer, pendant la phase intermédiaire ($\phi$"2), un signal de commande (VGATE_PS$_L$) présentant une variation graduelle sur la grille du second transistor (PS$_L$) pour basculer graduellement le second transistor (PS$_L$) à un état bloquant ;

    x- commander le premier transistor (PS$_H$) en régime linéaire pour appliquer la seconde rampe de tension sur le troisième noeud (103) durant la phase rapide ($\phi$"3) jusqu'au passage du premier transistor (PS$_H$) à un état passant.

6. Circuit de sélection d'une tension d'alimentation (VS$_j$) selon l'une quelconque des revendications 1 ou 2 dans lequel le circuit de configuration (CONF), pour réaliser une transition descendante, est configuré pour exécuter successivement les étapes suivantes :

    v- commander le premier transistor (PS$_H$) en régime linéaire pour appliquer la seconde rampe de tension sur le troisième noeud (103) durant la phase rapide ($\phi$'''1) ;

    vi- détecter le passage de la tension d'alimentation de sortie (VCORE) à un niveau supérieur à un niveau inférieur à un seuil prédéterminé supérieur la seconde tension d'alimentation d'entrée (VDD$_L$), ledit passage indiquant l'achèvement de la phase rapide ($\phi$'''1) ;

    vii- appliquer, pendant la phase lente ($\phi$'''2), un premier signal de commande (VGATE_PS$_L$) présentant une variation graduelle sur la grille du second transistor (PS$_L$) pour basculer graduellement le second transistor (PS$_L$) à un état passant ;

    viii- et appliquer un second signal de commande (VGATE_PS$_H$) présentant une variation graduelle sur la grille du premier transistor (PS$_H$) de manière à appliquer la première rampe de tension sur le troisième noeud (103) durant la phase lente ($\phi$'''2); pour basculer graduellement le premier transistor (PS$_H$) à un état bloquant.

7. Circuit de sélection d'une tension d'alimentation (VS$_j$) selon l'une quelconque des revendications de 3 à 6 précédentes dans lequel le circuit de contrôle (CONF) comprend :

    - un générateur de rampes de tension (RMP) pour générer:

        ◦ la première rampe de tension montante ou descendante (VCTRL) ;

        ◦ et/ou la deuxième rampe de tension montante ou descendante (VCTRL) sur un noeud de sortie (s_rmp) ;

    - et dans lequel le premier circuit de gestion de transition (CGT$_H$) comprend un premier circuit de régulation linéaire (LDO1) pour commander le premier transistor (PS$_H$) en régime linéaire, et ayant :

        ◦ un premier noeud d'entrée (Ido1_e1) connecté au troisième noeud (103) ;

        ◦ un deuxième noeud d'entrée (Ido1_e2) connecté au noeud de sortie (s_rmp) du générateur de rampes (RMP) ;

        ◦ et un noeud de sortie (Ido1_s) connecté à la grille du premier transistor (PS$_H$) à travers un premier interrupteur (i1).

8. Circuit de sélection d'une tension d'alimentation (VS$_j$) selon la revendication 7 dans lequel le premier circuit de régulation linéaire (LDO1) est configuré pour commander le premier transistor (PS$_H$) en régime linéaire via l'asservissement de la tension d'alimentation de sortie (VCORE) sur la rampe de tension (VCTRL) appliquée au deuxième noeud d'entrée (Ido1_e2) lorsque le premier interrupteur (i1) est passant.

9. Circuit de sélection d'une tension d'alimentation (VS$_j$) selon l'une quelconque des revendications de 7 ou 8 dans lequel le premier circuit de gestion de transition (CGT$_H$) comprend en outre un premier circuit de transition graduelle (TR_GR1) ayant un noeud de sortie (gr1_s) connecté à la grille du premier transistor (PS$_H$) à travers un deuxième interrupteur (i2), le premier circuit de transition graduelle (TR_GR1) étant apte appliquer un signal de commande (VGATE_PS$_H$) présentant une variation graduelle sur la grille du second transistor (PS$_L$) lorsque le deuxième interrupteur (i2) est passant.

10. Circuit de sélection d'une tension d'alimentation (VS$_j$) selon l'une quelconque des des revendications de 3 à 9 dans lequel le circuit de configuration (CONF) comprend en outre un second circuit de gestion de transition (CGT$_L$) comprenant :

- un second circuit de régulation linéaire (LDO2) ayant :

∘ un premier noeud d'entrée (ldo2_e1) connecté au troisième noeud (103) ;
∘ un deuxième noeud d'entrée (ldo2_e2) connecté au noeud de sortie (s_rmp) du générateur de rampes (RMP) ;
∘ et un noeud de sortie (ldo2_s) connecté à la grille du second transistor (PSL) à travers un troisième interrupteur (i3).

11. Circuit de sélection d'une tension d'alimentation (VS$_j$) selon la revendication précédente dans lequel le second circuit de gestion de transition (CGT$_L$) comprend un second circuit de transition graduelle (TR_GR2) ayant un noeud de sortie (gr2_s) connecté à la grille du second transistor (PS$_L$) à travers un quatrième interrupteur (i4), ledit circuit de transition graduelle (TR_GR) étant apte appliquer un signal de commande (VGATE_PS$_L$) sur la grille du second transistor (PS$_L$) lorsque le troisième interrupteur (i3) est passant ; ledit signal de commande (VGATE_PS$_L$) présentant une variation croissante ou décroissante graduelle.

12. Circuit de sélection d'une tension d'alimentation (VS$_j$) selon l'une quelconque des revendications précédentes dans lequel le circuit de configuration (CONF) comprend en outre un circuit (VCMP) de comparaison de la tension d'alimentation de sortie (VCORE) à un seuil prédéterminé.

13. Circuit de sélection d'une tension d'alimentation (VS$_j$) selon l'une quelconque des revendications précédentes dans lequel le circuit de configuration (CONF) comprend en outre un circuit (DEL) de génération d'une durée prédéterminé.

**Patentansprüche**

1. Schaltung zur Auswahl einer Versorgungsspannung (VS$_j$), Folgendes umfassend:

- einen ersten Knoten (101), der dazu angepasst ist, eine erste Eingangsversorgungsspannung (VDD$_H$) zu empfangen;
- einen zweiten Knoten (102), der dazu angepasst ist, eine zweite Eingangsversorgungsspannung (VDD$_L$) zu empfangen, die niedriger ist als die erste Eingangsversorgungsspannung (VDD$_H$);
- einen dritten Knoten (103), der dazu angepasst ist, eine Ausgangsversorgungsspannung (VCORE) bereitzustellen;
- einen ersten Leistungstransistor (PS$_H$), der den ersten Knoten (101) mit dem dritten Knoten (103) verbindet;
- einen zweiten Leistungstransistor (PS$_L$), der den zweiten Knoten (102) mit dem dritten Knoten (103) verbindet;
- und eine Konfigurationsschaltung (CONF), die in einer ersten Konfiguration dazu angepasst ist, den ersten (PS$_H$) und den zweiten (PS$_L$) Transistor jeweils eingeschaltet bzw. ausgeschaltet zu halten, um die erste Eingangsversorgungsspannung (VDD$_H$) an den dritten Knoten (103) anzulegen, und in einer zweiten Konfiguration dazu angepasst ist, den ersten (PS$_H$) und den zweiten (PS$_L$) Transistor jeweils im ausgeschalteten bzw. eingeschalteten Zustand zu halten, um die zweite Eingangsversorgungsspannung (VDD$_L$) an den dritten Knoten (103) anzulegen;

eine Übergangsphase von der ersten Konfiguration zur zweiten Konfiguration, die als Abwärtsübergang bezeichnet wird;
eine Übergangsphase von der ersten Konfiguration zur zweiten Konfiguration, die als Aufwärtsübergang bezeichnet wird;
wobei die Konfigurationsschaltung (CONF) Folgendes umfasst:

- eine erste Übergangs-Verwaltungsschaltung (CGT$_H$), die so konfiguriert ist, dass sie das Gatter des ersten Transistors (PS$_H$) während des Aufwärts- oder Abwärtsübergangs so ansteuert, dass an den dritten Knoten (103) Folgendes angelegt wird:

o mindestens eine erste Spannungsrampe mit einer ersten Flanke während einer ersten Dauer, die eine langsame Phase definiert (φ1, φ'2, φ"1, φ'''2);
o und eine zweite Spannungsrampe mit einer zweiten Flanke, die größer ist als die erste Flanke, während einer zweiten Dauer, die eine schnelle Phase definiert ($\phi$3, $\phi'$1, $\phi''$3, $\phi'''$1),

- eine zweite Übergangssteuerungsschaltung (CGT$_L$), die so konfiguriert ist, dass sie das Gatter des zweiten Transistors (PS$_L$) während des ansteigenden oder abfallenden Übergangs so ansteuert, dass ein Steuersignal (VGATE_PS$_L$) mit einer progressiven Änderung angelegt wird;

wobei, bei einem Aufwärtsübergang, die erste Spannungsrampe vor der zweiten Spannungsrampe angelegt wird; wobei, bei einem Abwärtsübergang, die zweite Spannungsrampe vor der ersten Spannungsrampe angelegt wird.

2. Schaltung zur Auswahl einer Versorgungsspannung (VS$_j$) nach Anspruch 1, wobei der Absolutwert der ersten Flanke zwischen einem Zehntel des Absolutwerts der zweiten Flanke und einem Fünftel des Absolutwerts der zweiten Flanke liegt.

3. Schaltung zur Auswahl einer Versorgungsspannung (VS$_j$) nach einem der Ansprüche 1 oder 2, wobei die Konfigurationsschaltung (CONF) zur Durchführung eines Aufwärtsübergangs so konfiguriert ist, dass sie nacheinander folgende Schritte ausführt:

vi- Ansteuern des ersten Transistors (PS$_H$) im linearen Betrieb, um die erste Spannungsrampe während der langsamen Phase ($\phi$1) an den dritten Knoten (103) anzulegen;
vii- Erfassen des Übergangs der Ausgangsversorgungsspannung (VCORE) auf einen Pegel oberhalb eines vorbestimmten Schwellenwerts, der niedriger als die erste Eingangsversorgungsspannung (VDD$_H$) ist, wobei der Übergang das Ende der langsamen Phase angibt;
viii- Ansteuern des ersten Transistors (PS$_H$) im linearen Betrieb, um während einer Zwischenphase ($\phi$2) zwischen der langsamen Phase und der schnellen Phase eine konstante Spannung an den dritten Knoten (103) anzulegen;
ix- und während der Zwischenphase ($\phi$2), Anlegen eines Steuersignals (VGATE_PS$_L$) mit einer progressiven Änderung an das Gatter des zweiten Transistors (PS$_L$), um den zweiten Transistor (PS$_L$) progressiv in einen ausgeschalteten Zustand zu schalten;
x- Ansteuern des ersten Transistors (PS$_H$) im linearen Betrieb, um die zweite Spannungsrampe an den dritten Knoten (103) während der schnellen Phase ($\phi$3) anzulegen, bis der erste Transistor (PS$_H$) in einen eingeschalteten Zustand übergeht.

4. Schaltung zur Auswahl einer Versorgungsspannung (VS$_j$) nach einem der Ansprüche 1 oder 2, wobei die Konfigurationsschaltung (CONF) zur Durchführung eines Abwärtsübergangs so konfiguriert ist, dass sie nacheinander folgende Schritte ausführt:

v- Ansteuern des ersten Transistors (PS$_H$) im linearen Betrieb, um die zweite Spannungsrampe während der schnellen Phase ($\phi'$1) an den dritten Knoten (103) anzulegen;
vi- Erfassen des Übergangs der Ausgangsversorgungsspannung (VCORE) auf einen Pegel, der größer als ein Pegel ist, der kleiner als ein vorbestimmter Schwellenwert, der größer als die zweite Eingangsversorgungsspannung (VDD$_L$) ist, wobei der Übergang die Vollendung der schnellen Phase ($\phi'$1) angibt;
vii- während der langsamen Phase ($\phi'$2), Anlegen eines Steuersignals (VGATE_PS$_L$) mit einer progressiven Änderung an das Gatter des zweiten Transistors (PS$_L$), um den zweiten Transistor (PSL) progressiv in einen eingeschalteten Zustand zu schalten;
viii- und Ansteuern des ersten Transistors (PS$_H$) im linearen Betrieb, um die erste Spannungsrampe an den dritten Knoten (103) während der langsamen Phase ($\phi'$2) anzulegen, bis der erste Transistor (PS$_H$) in einen ausgeschalteten Zustand übergeht.

5. Schaltung zur Auswahl einer Versorgungsspannung (VS$_j$) nach einem der Ansprüche 1 oder 2, wobei die Konfigurationsschaltung (CONF) zur Durchführung eines Aufwärtsübergangs so konfiguriert ist, dass sie nacheinander folgende Schritte ausführt:

vi- Anlegen eines zweiten Steuersignals (VGATE_PS$_H$) mit einer progressiven Änderung an das Gatter des ersten Transistors (PS$_H$) während der langsamen Phase ($\phi''$1);
vii- Erfassen des Übergangs der Ausgangsversorgungsspannung (VCORE) auf einen Pegel oberhalb eines vorbestimmten Schwellenwerts, der niedriger als die erste Eingangsversorgungsspannung (VDD$_H$) ist, wobei der Übergang das Ende der langsamen Phase angibt;
viii- Ansteuern des ersten Transistors (PS$_H$) im linearen Betrieb, um während einer Zwischenphase ($\phi''$2) zwischen der langsamen Phase und der schnellen Phase eine konstante Spannung an den dritten Knoten (103) anzulegen;
ix- und während der Zwischenphase ($\phi''$2), Anlegen eines Steuersignals (VGATE_PS$_L$) mit einer progressiven Änderung an das Gatter des zweiten Transistors (PS$_L$), um den zweiten Transistor (PS$_L$) progressiv in einen ausgeschalteten Zustand zu schalten;
x- Ansteuern des ersten Transistors (PS$_H$) im linearen Betrieb, um die zweite Spannungsrampe an den dritten Knoten (103) während der

schnellen Phase ($\phi$"3) anzulegen, bis der erste Transistor (PS$_H$) in einen eingeschalteten Zustand übergeht.

6.  Schaltung zur Auswahl einer Versorgungsspannung (VS$_j$) nach einem der Ansprüche 1 oder 2, wobei die Konfigurationsschaltung (CONF) zur Durchführung eines Abwärtsübergangs so konfiguriert ist, dass sie nacheinander folgende Schritte ausführt:

> v- Ansteuern des ersten Transistors (PS$_H$) im linearen Betrieb, um die zweite Spannungsrampe während der schnellen Phase ($\phi'''$1) an den dritten Knoten (103) anzulegen;
> vi- Erfassen des Übergangs der Ausgangsversorgungsspannung (VCORE) auf einen Pegel, der größer als ein Pegel ist, der kleiner als ein vorbestimmter Schwellenwert, der größer als die zweite Eingangsversorgungsspannung (VDD$_L$) ist, wobei der Übergang die Vollendung der schnellen Phase ($\phi'''$1) angibt;
> vii- während der langsamen Phase ($\phi'''$2), Anlegen eines ersten Steuersignals (VGATE_PS$_L$) mit einer progressiven Änderung an das Gatter des zweiten Transistors (PS$_L$), um den zweiten Transistor (PSL) progressiv in einen eingeschalteten Zustand zu schalten;
> viii- und Anlegen eines zweiten Steuersignals (VGATE_PS$_H$) mit einer progressiven Änderung an das Gatter des ersten Transistors (PS$_H$), um die erste Spannungsrampe an den dritten Knoten (103) während der langsamen Phase ($\phi'''$2) anzulegen; um den ersten Transistor (PS$_H$) progressiv in einen ausgeschalteten Zustand zu schalten.

7.  Schaltung zur Auswahl einer Versorgungsspannung (VS$_j$) nach einem der vorhergehenden Ansprüche 3 bis 6, wobei die Steuerschaltung (CONF) Folgendes umfasst:

> - einen Spannungsrampengenerator (RMP) zum Erzeugen:

>> ◦ der ersten ansteigenden oder abfallenden Spannungsrampe (VCTRL);
>> ◦ und/oder der zweiten ansteigenden oder abfallenden Spannungsrampe (VCTRL) an einem Ausgangsknoten (s_rmp);

> - und wobei die erste Übergangs-Verwaltungsschaltung (CGT$_H$) eine erste lineare Regelschaltung (LDO1) zum Steuern des ersten Transistors (PS$_H$) in einem linearen Regime umfasst, und Folgendes aufweist:

>> ◦ einen ersten Eingangsknoten (ldo1_e1), der mit dem dritten Knoten (103) verbunden ist;
>> ◦ einen zweiten Eingangsknoten (ldo1_e2), der mit dem Ausgangsknoten (s_rmp) des Rampengenerators (RMP) verbunden ist;
>> ◦ und einen Ausgangsknoten (ldo1_s), der über einen ersten Schalter (i1) mit dem Gatter des ersten Transistors (PS$_H$) verbunden ist.

8.  Schaltung zur Auswahl einer Versorgungsspannung (VS$_j$) nach Anspruch 7, wobei die erste lineare Regelschaltung (LDO1) so konfiguriert ist, dass sie den ersten Transistor (PS$_H$) über die Nachführung der Ausgangsversorgungsspannung (VCORE) auf die an den zweiten Eingangsknoten (ldo1_e2) angelegte Spannungsrampe (VCTRL) in einem linearen Regime steuert, wenn der erste Schalter (i1) eingeschaltet ist.

9.  Schaltung zur Auswahl einer Versorgungsspannung (VS$_j$) nach einem der Ansprüche 7 oder 8, wobei die erste Übergangs-Verwaltungsschaltung (CGT$_H$) ferner eine erste progressive Übergangsschaltung (TR_GR1) umfasst, die einen Ausgangsknoten (gr1_s) aufweist, der über einen zweiten Schalter (i2) mit dem Gatter des ersten Transistors (PS$_H$) verbunden ist, wobei die erste progressive Übergangsschaltung (TR_GR1) in der Lage ist, ein Steuersignal (VGATE_PS$_H$) mit einer progressiven Änderung an das Gatter des zweiten Transistors (PS$_L$) anzulegen, wenn der zweite Schalter (i2) eingeschaltet ist.

10. Schaltung zur Auswahl einer Versorgungsspannung (VS$_j$) nach einem der Ansprüche 3 bis 9, wobei die Konfigurationsschaltung (CONF) ferner eine zweite Übergangs-Verwaltungsschaltung (CGT$_L$) umfasst, die Folgendes umfasst:

> - einen zweiten linearen Regelkreis (LDO2), der Folgendes aufweist:

>> ◦ einen ersten Eingangsknoten (ldo2_e1), der mit dem dritten Knoten (103) verbunden ist;
>> ◦ einen zweiten Eingangsknoten (ldo2_e2), der mit dem Ausgangsknoten (s_rmp) des Rampengenerators (RMP) verbunden ist;
>> ◦ und einen Ausgangsknoten (ldo2_s), der über einen dritten Schalter (i3) mit dem Gatter des zweiten Transistors (PS$_L$) verbunden ist.

11. Schaltung zur Auswahl einer Versorgungsspannung (VS$_j$) nach dem vorhergehenden Anspruch, wobei die zweite Übergangs-Verwaltungsschaltung (CGT$_L$) eine zweite progressive Übergangsschaltung (TR_GR2) umfasst, die einen Ausgangsknoten (gr2_s) aufweist, der über einen vierten Schalter (i4) mit dem Gatter des zweiten Transistors ($PS_L$) verbunden ist, wobei die progressive Übergangsschaltung (TR_GR) in der Lage ist, ein Steuersignal (VGATE _$PS_L$) an das Gatter des zweiten Transistors ($PS_L$) anzulegen, wenn der dritte Schalter (i3) eingeschaltet ist; wobei das Steuersignal (VGATE _$PS_L$) eine progressiv ansteigende oder abfallende Änderung aufweist.

12. Schaltung zur Auswahl einer Versorgungsspannung ($VS_j$) nach einem der vorhergehenden Ansprüche, wobei die Konfigurationsschaltung (CONF) ferner eine Schaltung (VCMP) zum Vergleichen der Ausgangsversorgungsspannung (VCORE) mit einem vorbestimmten Schwellenwert umfasst.

13. Schaltung zur Auswahl einer Versorgungsspannung ($VS_j$) nach einem der vorhergehenden Ansprüche, wobei die Konfigurationsschaltung (CONF) ferner eine Schaltung (DEL) zum Erzeugen einer vorbestimmten Zeitdauer umfasst.

**Claims**

1. A circuit for selecting a supply voltage ($VS_j$), comprising:

   - a first node (101) designed to receive a first input supply voltage ($VDD_H$);
   - a second node (102) designed to receive a second input supply voltage ($VDD_L$) less than the first input supply voltage ($VDD_H$);
   - a third node (103) designed to supply an output supply voltage (VCORE);
   - a first power transistor ($PS_H$) connecting the first node (101) to the third node (103);
   - a second power transistor ($PS_L$) connecting the second node (102) to the third node (103);
   - and a configuration circuit (CONF) designed, in a first configuration, to keep the first ($PS_H$) and second ($PS_L$) transistors respectively in the on state and in the off state so as to apply the first input supply voltage ($VDD_H$) to the third node (103) and, in a second configuration, to keep the first ($PS_H$) and second ($PS_L$) transistors respectively in the off state and in the on state so as to apply the second input supply voltage ($VDD_L$) to the third node (103);

      a transition phase from the first configuration to the second configuration being called downward transition;
      a transition phase from the second configuration to the first configuration being called upward transition;
      the configuration circuit (CONF) comprising:

   - a first transition management circuit ($CGT_H$) configured to control the gate of the first transistor ($PS_H$) upon the upward or downward transition so as to apply, to the third node (103):

      ∘ at least one first voltage ramp having a first slope for a first duration defining a slow phase ($\phi1$, $\phi'2$, $\phi''1$, $\phi'''2$);
      ∘ and a second voltage ramp having a second slope, greater than the first slope, for a second duration defining a fast phase ($\phi3$, $\phi'1$, $\phi''3$, $\phi'''1$),

   - a second transition management circuit ($CGT_L$) configured to control the gate of the second transistor ($PS_L$) upon the upward or downward transition so as to apply a control signal (VGATE_$PS_L$) having a gradual variation;

   upon an upward transition, the first voltage ramp being applied before the second voltage ramp; upon a downward transition, the second voltage ramp being applied before the first voltage ramp.

2. The circuit for selecting a supply voltage ($VS_j$) according to claim 1, wherein the absolute value of the first slope is between one tenth of the absolute value of the second slope and one fifth of the absolute value of the second slope.

3. The circuit for selecting a supply voltage ($VS_j$) according to any one of claim 1 or 2, wherein the configuration circuit (CONF), to perform an upward transition, is configured to successively execute the following steps:

   vi- controlling the first transistor ($PS_H$) in linear regime to apply the first voltage ramp to the third node (103) during the slow phase ($\phi1$);
   vii- detecting the change of the output supply voltage (VCORE) to a level greater than a predetermined threshold less than the first input supply voltage ($VDD_H$), said change indicating the end of the slow phase;
   viii- controlling the first transistor ($PS_H$) in linear regime to apply a constant voltage to the third node (103) during an intermediate phase ($\phi2$) between the slow phase and the fast phase;
   ix- and applying, during the intermediate phase ($\phi2$), a control signal (VGATE_$PS_L$) having a gradual variation to the gate of the second transistor ($PS_L$) to gradually switch the second transistor ($PS_L$) to an off state;
   x- controlling the first transistor ($PS_H$) in linear regime to apply the second voltage ramp to the third node (103) during the fast phase ($\phi3$) until the first transistor ($PS_H$) changes to an on state.

**4.** The circuit for selecting a supply voltage (VS$_j$) according to any one of claim 1 or 2, wherein the configuration circuit (CONF), to perform a downward transition, is configured to successively execute the following steps:

> v- controlling the first transistor (PS$_H$) in linear regime to apply the second voltage ramp to the third node (103) during the fast phase ($\phi$'1);
> vi- detecting the change of the output supply voltage (VCORE) to a level greater than a level lower than a predetermined threshold greater than the second input supply voltage (VDD$_L$), said change indicating the end of the fast phase ($\phi$'1);
> vii- applying, during the slow phase ($\phi$'2), a control signal (VGATE _PS$_L$) having a gradual variation to the gate of the second transistor (PS$_L$) so as to gradually switch the second transistor (PS$_L$) to an on state;
> viii- and controlling the first transistor (PS$_H$) in linear regime so as to apply the first voltage ramp to the third node (103) during the slow phase ($\phi$'2) until the first transistor (PS$_H$) changes to an off state.

**5.** The circuit for selecting a supply voltage (VS$_j$) according to any one of claim 1 or 2, wherein the configuration circuit (CONF), to perform an upward transition, is configured to successively execute the following steps:

> vi- applying a second control signal (VGATE _PS$_H$) having a gradual variation to the gate of the first transistor (PS$_H$) during the slow phase ($\phi$"1);
> vii- detecting the change of the output supply voltage (VCORE) to a level greater than a predetermined threshold less than the first input supply voltage (VDD$_H$), said change indicating the end of the slow phase;
> viii- controlling the first transistor (PS$_H$) in linear regime so as to apply a constant voltage to the third node (103) during an intermediate phase ($\phi$"2) between the slow phase and the fast phase;
> ix- and applying, during the intermediate phase ($\phi$"2), a control signal (VGATE_PS$_L$) having a gradual variation to the gate of the second transistor (PS$_L$) to gradually switch the second transistor (PS$_L$) to an off state;
> x- controlling the first transistor (PS$_H$) in linear regime to apply the second voltage ramp to the third node (103) during the fast phase ($\phi$"3) until the first transistor (PS$_H$) changes to an on state.

**6.** The circuit for selecting a supply voltage (VS$_j$) according to any one of claims 1 or 2, wherein the configuration circuit (CONF), to perform a downward transition, is configured to successively execute the following steps:

> v- controlling the first transistor (PS$_H$) in linear regime to apply the second voltage ramp to the third node (103) during the fast phase ($\phi$'''1);
> vi- detecting the change of the output supply voltage (VCORE) to a level greater than a level lower than a predetermined threshold greater than the second input supply voltage (VDD$_L$), said change indicating the end of the fast phase ($\phi$'''1);
> vii- applying, during the slow phase ($\phi$'''2), a first control signal (VGATE _PS$_L$) having a gradual variation to the gate of the second transistor (PS$_L$) to gradually switch the second transistor (PS$_L$) to an on state;
> viii- and applying a second control signal (VGATE _PS$_H$) having a gradual variation to the gate of the first transistor (PS$_H$) to apply the first voltage ramp to the third node (103) during the slow phase ($\phi$'''2); to gradually switch the first transistor (PS$_H$) to an off state.

**7.** The circuit for selecting a supply voltage (VS$_j$) according to any one of claims 3 to 6, wherein the control circuit (CONF) comprises:

> - a voltage ramp generator (RMP) for generating:
>
> > ∘ the first upward or downward voltage ramp (VCTRL);
> > ∘ and/or the second upward or downward voltage ramp (VCTRL) on an output node (s_rmp);
>
> - and wherein the first transition management circuit (CGT$_H$) comprises a first linear regulation circuit (LDO1) for controlling the first transistor (PS$_H$) in linear regime, and having:
>
> > ∘ a first input node (ldo1_e1) connected to the third node (103);
> > ∘ a second input node (ldo1_e2) connected to the output node (s_rmp) of the ramp generator (RMP);
> > ∘ and an output node (ldo1_s) connected to the gate of the first transistor (PS$_H$) via a first switch (i1).

**8.** The circuit for selecting a supply voltage (VS$_j$) according to claim 7, wherein the first linear regulation circuit (LDO1) is configured to control the first transistor (PS$_H$) in linear regime by slaving the output supply voltage (VCORE) to the voltage ramp (VCTRL) applied to the second input node (ldo1_e2) when the first switch (i1) is in the on state.

9. The circuit for selecting a supply voltage (VS$_j$) according to any one of claim 7 or 8, wherein the first transition management circuit (CGT$_H$) further comprises a first gradual transition circuit (TR_GR1) having an output node (gr1_s) connected to the gate of the first transistor (PS$_H$) via a second switch (i2), the first gradual transition circuit (TR_GR1) being able to apply a control signal (VGATE_PS$_H$) having a gradual variation to the gate of the second transistor (PS$_L$) when the second switch (i2) is in the on state.

10. The circuit for selecting a supply voltage (VS$_j$) according to any one of claims 3 to 9, wherein the configuration circuit (CONF) further comprises a second transition management circuit (CGT$_L$) comprising:

> - a second linear regulation circuit (LDO2) having:
>
>> ∘ a first input node (ldo2_e1) connected to the third node (103);
>> ∘ a second input node (Ido2_e2) connected to the output node (s_rmp) of the ramp generator (RMP);
>> ∘ and an output node (Ido2_s) connected to the gate of the second transistor (PS$_L$) via a third switch (i3).

11. The circuit for selecting a supply voltage (VS$_j$) according to the preceding claim, wherein the second transition management circuit (CGT$_L$) comprises a second gradual transition circuit (TR_GR2) having an output node (gr2_s) connected to the gate of the second transistor (PS$_L$) via a fourth switch (i4), said gradual transition circuit (TR_GR) being able to apply a control signal (VGATE_PS$_L$) to the gate of the second transistor (PS$_L$) when the third switch (i3) is in the on state; said control signal (VGATE_PS$_L$) having an increasing or decreasing gradual variation.

12. The circuit for selecting a supply voltage (VS$_j$) according to any one of the preceding claims, wherein the configuration circuit (CONF) further comprises a circuit (VCMP) for comparing the output supply voltage (VCORE) to a predetermined threshold.

13. The circuit for selecting a supply voltage (VS$_j$) according to any one of the preceding claims, wherein the configuration circuit (CONF) further comprises a circuit (DEL) for generating a predetermined duration.

EP 4 106 199 B1

FIG.1a

FIG.1b

FIG.2a

FIG.2b

FIG.2c

FIG.2d

FIG.3a

EP 4 106 199 B1

FIG.3b

FIG.3c

FIG.3d

33

FIG.3e

FIG.4a

EP 4 106 199 B1

FIG.4b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3267583 B1
- US 10439602 B2
- US 10432184 B1

- EP 3734398 A1
- EP 1993019 A1
- US 2005057952 A1